(19) Europäisches Patentamt
European Patent Office
Office européen des brevets

(11) **EP 3 767 679 B1**

(12) **FASCICULE DE BREVET EUROPEEN**

(45) Date de publication et mention
de la délivrance du brevet:
**02.03.2022 Bulletin 2022/09**

(51) Classification Internationale des Brevets (IPC):
*H01L 27/30* (2006.01)    *H01L 51/44* (2006.01)
*H04N 5/369* (2011.01)    *H01L 27/146* (2006.01)

(21) Numéro de dépôt: **20186100.2**

(22) Date de dépôt: **16.07.2020**

(52) Classification Coopérative des Brevets (CPC):
**H01L 51/447; H01L 27/14609; H01L 27/14621;
H01L 27/14627; H01L 27/14636; H01L 27/307;
Y02E 10/549**

(54) **PIXEL DE CAPTEUR D'IMAGES**

PIXEL EINES BILDSENSORS

IMAGE SENSOR PIXEL

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **19.07.2019 FR 1908254**

(43) Date de publication de la demande:
**20.01.2021 Bulletin 2021/03**

(73) Titulaire: **ISORG
87068 Limoges Cedex 3 (FR)**

(72) Inventeurs:
• **DUPOIRON, Camille
38000 GRENOBLE (FR)**
• **BOUTHINON, Benjamin
38000 GRENOBLE (FR)**

(74) Mandataire: **Cabinet Beaumont
4, Place Robert Schuman
B.P. 1529
38025 Grenoble Cedex 1 (FR)**

(56) Documents cités:
**EP-A1- 2 980 850**    **EP-A1- 3 209 012**
**EP-A2- 3 059 950**    **DE-A1-102016 102 111**
**US-A1- 2015 221 702**    **US-A1- 2019 131 349**

## Description

### Domaine technique

La présente demande concerne un pixel d'un capteur d'images ou imageur électronique, un capteur d'images ou imageur électronique comportant de tels pixels et un procédé de fabrication d'un tel pixel.

### Technique antérieure

Des capteurs d'images sont actuellement utilisés dans de nombreux domaines, en particulier dans les dispositifs électroniques. On retrouve notamment des capteurs d'images dans des applications d'interface homme-machine et de prise d'images. Des domaines d'utilisation de tels capteurs d'images sont, par exemple, les téléphones intelligents, l'automobile, les drones, la robotique et les systèmes à réalité virtuelle ou augmentée.

Dans certaines applications, un même dispositif électronique peut disposer de plusieurs capteurs d'images de différents types. Un tel dispositif peut ainsi comporter, par exemple, un premier capteur d'images en couleur, un deuxième capteur d'images infrarouge, un troisième capteur d'images permettant d'évaluer une distance, par rapport au dispositif, de différents points d'une scène ou d'un sujet, etc.

Cette multiplicité de capteurs d'images embarqués dans un même dispositif est, par nature, peu compatible avec les contraintes actuelles de miniaturisation de ces dispositifs.

Le document DE102016102111 décrit un capteur d'images et un dispositif d'imagerie comportant ce capteur.

Le document EP2980850 décrit un élément d'imagerie et un équipement électronique.

Le document US2019131349 décrit un capteur d'images.

Le document US2015221702 décrit un capteur d'images et un dispositif de traitement d'images.

Le document EP3209012 décrit un dispositif électronique et son procédé de fonctionnement.

### Résumé de l'invention

Il existe un besoin d'améliorer les capteurs d'images existants.

Un mode de réalisation pallie tout ou partie des inconvénients des capteurs d'images connus.

Un pixel selon l'invention est défini dans la revendication 1. Des modes de réalisation préférés sont définis dans des revendications dépendantes.

### Brève description des dessins

Les caractéristiques et avantages, ainsi que d'autres, seront exposés en détail dans la description suivante de modes de réalisation et modes de mise en œuvre particuliers faite à titre non limitatif en relation avec les figures jointes parmi lesquelles :

La figure 1 est une vue en perspective éclatée, schématique et partielle, d'un mode de réalisation d'un capteur d'images ;

La figure 2 est une vue de dessus, schématique et partielle, du capteur d'images de la figure 1 ;

La figure 3 est un schéma électrique d'un mode de réalisation de circuits de lecture d'un pixel du capteur d'images des figures 1 et 2 ;

La figure 4 est un chronogramme de signaux d'un exemple de fonctionnement du capteur d'images ayant les circuits de lecture de la figure 3 ;

La figure 5 est une vue en coupe, schématique et partielle, d'une étape d'un mode de mise en œuvre d'un procédé de réalisation du capteur d'images des figures 1 et 2 ;

La figure 6 est une vue en coupe, schématique et partielle, d'une autre étape du mode de mise en œuvre du procédé de réalisation du capteur d'images des figures 1 et 2 ;

La figure 7 est une vue en coupe, schématique et partielle, d'encore une autre étape du mode de mise en œuvre du procédé de réalisation du capteur d'images des figures 1 et 2 ;

La figure 8 est une vue en coupe, schématique et partielle, d'encore une autre étape du mode de mise en œuvre du procédé de réalisation du capteur d'images des figures 1 et 2 ;

La figure 9 est une vue en coupe, schématique et partielle, d'encore une autre étape du mode de mise en œuvre du procédé de réalisation du capteur d'images des figures 1 et 2 ;

La figure 10 est une vue en coupe, schématique et partielle, d'encore une autre étape du mode de mise en œuvre du procédé de réalisation du capteur d'images des figures 1 et 2 ;

La figure 11 est une vue en coupe, schématique et partielle, d'encore une autre étape du mode de mise en œuvre du procédé de réalisation du capteur d'images des figures 1 et 2 ;

La figure 12 est une vue en coupe, schématique et partielle, d'encore une autre étape du mode de mise en œuvre du procédé de réalisation du capteur d'images des figures 1 et 2 ;

La figure 13 est une vue en coupe, schématique et partielle, d'encore une autre étape du mode de mise en œuvre du procédé de réalisation du capteur d'images des figures 1 et 2 ;

La figure 14 est une vue en coupe, schématique et partielle, d'encore une autre étape du mode de mise en œuvre du procédé de réalisation du capteur d'images des figures 1 et 2 ;

La figure 15 est une vue en coupe, schématique et partielle, d'encore une autre étape du mode de mise en œuvre du procédé de réalisation du capteur d'images des figures 1 et 2 ;

La figure 16 est une vue en coupe selon le plan AA, schématique et partielle, du capteur d'images des figures 1 et 2 ;

La figure 17 est une vue en coupe selon le plan BB, schématique et partielle, du capteur d'images des figures 1 et 2 ; et

La figure 18 est une vue en coupe, schématique et partielle, d'un autre mode de réalisation d'un capteur d'images.

Description des modes de réalisation

De mêmes éléments ont été désignés par de mêmes références dans les différentes figures. En particulier, les éléments structurels et/ou fonctionnels communs aux différents modes de réalisation et modes de mise en œuvre peuvent présenter les mêmes références et peuvent disposer de propriétés structurelles, dimensionnelles et matérielles identiques.

Par souci de clarté, seuls les étapes et éléments utiles à la compréhension des modes de réalisation et modes de mise en œuvre décrits ont été représentés et sont détaillés. En particulier, l'utilisation faite des capteurs d'images décrits ci-après n'a pas été détaillée.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence, sauf précision contraire, à l'orientation des figures ou à un capteur d'images dans une position normale d'utilisation.

Sauf précision contraire, les expressions "environ", "approximativement", "sensiblement", et "de l'ordre de" signifient à 10 % près, de préférence à 5 % près.

Dans la description qui suit, on appelle "signal binaire" un signal qui alterne entre un premier état constant, par exemple un état bas, noté "0", et un deuxième état constant, par exemple un état haut, noté "1". Les états haut et bas de signaux binaires différents d'un même circuit électronique peuvent être différents. En pratique, les signaux binaires peuvent correspondre à des tensions ou à des courants qui peuvent ne pas être parfaitement constants à l'état haut ou bas.

Dans la description qui suit, on considère, sauf précision contraire, que les termes "isolant" et "conducteur" signifient respectivement "isolant électriquement" et "conducteur électriquement".

La transmittance d'une couche à un rayonnement correspond au rapport entre l'intensité du rayonnement sortant de la couche et l'intensité du rayonnement entrant dans la couche, les rayons du rayonnement entrant étant perpendiculaires à la couche. Dans la suite de la description, une couche ou un film est dit opaque à un rayonnement lorsque la transmittance du rayonnement au travers de la couche ou du film est inférieure à 10 %. Dans la suite de la description, une couche ou un film est dit transparent à un rayonnement lorsque la transmittance du rayonnement au travers de la couche ou du film est supérieure à 10 %.

Dans la description qui suit, on appelle lumière visible un rayonnement électromagnétique dont la longueur d'onde est comprise entre 400 nm et 700 nm et on appelle rayonnement infrarouge un rayonnement électromagnétique dont la longueur d'onde est comprise entre 700 nm et 1 mm. Dans le rayonnement infrarouge, on distingue notamment le rayonnement infrarouge proche, dont la longueur d'onde est comprise entre 700 nm et 1,7 $\mu$m.

Un pixel d'une image correspond à l'élément unitaire de l'image captée par un capteur d'images. Lorsque le dispositif optoélectronique est un capteur d'images couleur, il comprend en général, pour chaque pixel de l'image couleur à acquérir, au moins trois composants qui font l'acquisition chacun d'un rayonnement lumineux sensiblement dans une seule couleur, c'est-à-dire dans une plage de longueurs d'onde de largeur inférieure à 130 nm (par exemple, le rouge, le vert et le bleu). Chaque composant peut comprendre notamment au moins un photodétecteur.

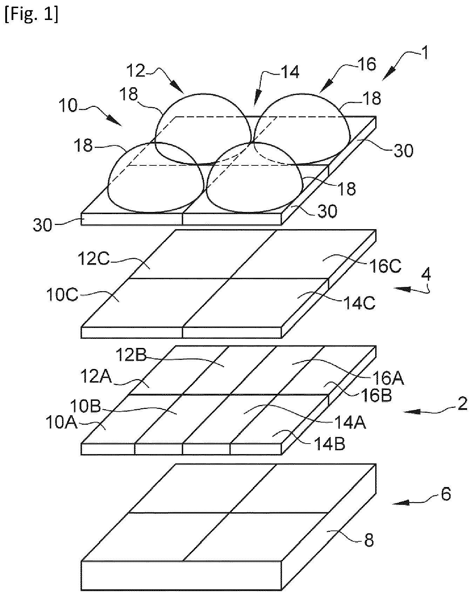

La figure 1 est une vue en perspective éclatée, schématique et partielle, d'un mode de réalisation d'un capteur d'images 1.

Le capteur d'images 1 comporte plusieurs pixels, par exemple plusieurs millions voire plusieurs dizaines de millions de pixels. Toutefois, pour simplifier, seuls quatre pixels 10, 12, 14 et 16 du capteur d'images 1 ont été représentés en figure 1, étant entendu que, en pratique, le capteur d'images 1 peut comporter davantage de pixels. Ces pixels du capteur d'images 1 peuvent être répartis en rangées (ou lignes) et en colonnes.

Le capteur d'images 1 comporte une première matrice 2 de capteurs de photons, également appelés photodétecteurs, et une deuxième matrice 4 de photodétecteurs. Dans ce capteur d'images 1, chaque pixel 10, 12, 14, 16 comporte trois photodétecteurs appartenant chacun à l'une ou à l'autre de ces deux matrices 2, 4 de photodétecteurs.

En figure 1, chaque pixel 10, 12, 14, 16 du capteur d'images 1 comporte plus particulièrement :

un premier photodétecteur, appartenant à la première matrice 2 de photodétecteurs et repéré par le suffixe « A » ;
un deuxième photodétecteur, appartenant également à la première matrice 2 de photodétecteurs et repéré par le suffixe « B » ; et
un troisième photodétecteur, appartenant à la deuxième matrice 4 de photodétecteurs et repéré par le suffixe « C ».

Ainsi, en figure 1 :

le pixel 10 comporte un premier photodétecteur 10A, un deuxième photodétecteur 10B et un troisième photodétecteur 10C ;
le pixel 12 comporte un premier photodétecteur 12A, un deuxième photodétecteur 12B et un troisième photodétecteur 12C ;
le pixel 14 comporte un premier photodétecteur 14A, un deuxième photodétecteur 14B et un troisième photodétecteur 14C ; et
le pixel 16 comporte un premier photodétecteur 16A, un deuxième photodétecteur 16B et un troisième photodétecteur 16C.

Les photodétecteurs 10A, 10B, 10C, 12A, 12B, 12C, 14A, 14B, 14C, 16A, 16B et 16C peuvent correspondre à des photodiodes organiques (Organic Photodiode - OPD) ou à des photorésistances organiques. Dans la description qui suit, on considère que les photodétecteurs des pixels du capteur d'images 1 correspondent à des photodiodes organiques.

Dans le capteur d'images 1, chaque pixel 10, 12, 14, 16 comporte en outre une lentille 18, également appelée microlentille 18 en raison de ses dimensions, et un filtre couleur 30 situé sous cette microlentille 18. Dans la représentation simplifiée de la figure 1, les filtres couleur 30 sont intercalés entre la deuxième matrice 4 de photodétecteurs et les microlentilles 18.

La première matrice 2 de photodétecteurs et la deuxième matrice 4 de photodétecteurs sont superposées, de sorte que les troisièmes photodétecteurs 10C, 12C, 14C, 16C sont superposés à la fois aux premiers photodétecteurs 10A, 12A, 14A, 16A et aux deuxièmes photodétecteurs 10B, 12B, 14B, 16B. Dans le capteur d'images 1, les premiers photodétecteurs 10A, 12A, 14A, 16A et les deuxièmes photodétecteurs 10B, 12B, 14B, 16B sont coplanaires.

La première matrice 2 de premiers photodétecteurs 10A, 12A, 14A, 16A et de deuxièmes photodétecteurs 10B, 12B, 14B, 16B ainsi que la deuxième matrice 4 de troisièmes photodétecteurs 10C, 12C, 14C, 16C sont toutes deux associées à une troisième matrice 6 de circuits de lecture, réalisant la mesure des signaux captés par les photodétecteurs de ces matrices 2 et 4. Par circuit de lecture, on entend un ensemble de transistors de lecture, d'adressage et de commande d'un photodétecteur. Plus généralement, les circuits de lecture associés aux différents photodétecteurs d'un même pixel forment conjointement un circuit de lecture du pixel considéré.

Selon ce mode de réalisation, la troisième matrice 6 de circuits de lecture du capteur d'images 1 est réalisée dans un support CMOS 8. Le support CMOS 8 est, par exemple, un morceau de plaquette de silicium sur et à l'intérieur duquel des circuits intégrés (non représentés) ont été réalisés en technologie CMOS (Complementary Metal Oxide Semiconductor). Ces circuits intégrés constituent, toujours selon ce mode de réalisation, la troisième matrice 6 de circuits de lecture. Dans la représentation simplifiée de la figure 1, la première matrice 2 de photodétecteurs recouvre la troisième matrice 6 de circuits de lecture, de sorte que ces deux matrices 2, 6 sont superposées.

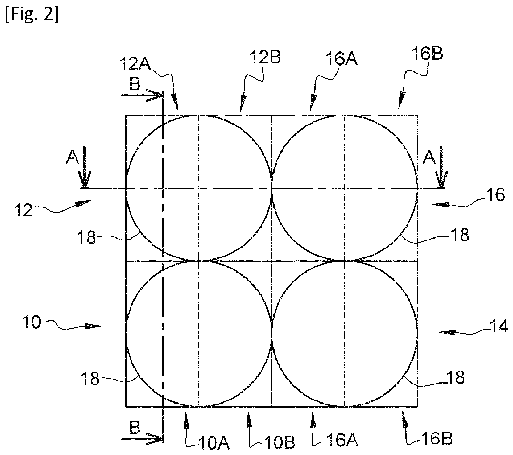

La figure 2 est une vue de dessus, schématique et partielle, du capteur d'images 1 de la figure 1. Dans cette vue de dessus, seules les microlentilles 18, les premiers photodétecteurs 10A, 12A, 14A et 16A et les deuxièmes photodétecteurs 10B, 12B, 14B et 16B des pixels 10, 12, 14 et 16 du capteur d'images 1 ont été représentés.

Dans le capteur d'images 1, vu de dessus en figure 2, les pixels 10, 12, 14 et 16 sont sensiblement de forme carrée, de préférence de forme carrée. Tous les pixels du capteur d'images 1 présentent préférentiellement des dimensions identiques, aux dispersions de fabrication près.

Le carré formé par chaque pixel 10, 12, 14, 16 du capteur d'images 1, vu de dessus en figure 2, a un côté compris entre environ 0,8 $\mu$m et 10 $\mu$m, de préférence compris entre environ 0,8 $\mu$m et 5 $\mu$m, encore plus préférentiellement compris entre 0,8 $\mu$m et 3 $\mu$m.

Le premier photodétecteur et le deuxième photodétecteur appartenant à un même pixel, par exemple, le premier photodétecteur 10A et le deuxième photodétecteur 10B du pixel 10, sont tous deux de forme rectangulaire. Ces photodétecteurs possèdent sensiblement les mêmes dimensions et s'inscrivent conjointement dans le carré formé par le pixel auquel ils appartiennent, le pixel 10 dans cet exemple. Le rectangle formé par chaque photodétecteur de chaque pixel du capteur d'images 1 a une longueur sensiblement égale au côté du carré formé par chaque pixel et une largeur sensiblement égale à la moitié du côté du carré formé par chaque pixel. Un espace est toutefois ménagé entre le premier et le deuxième photodétecteur de chaque pixel, de telle sorte que leurs électrodes inférieures respectives sont disjointes.

Dans le capteur d'images 1, chaque microlentille 18 présente, vue de dessus en figure 2, un diamètre sensiblement égal, de préférence égal, au côté du carré conjointement formé par les premier et deuxième photodétecteurs qu'elle recouvre. Dans le présent mode de réalisation, chaque pixel comporte une seule microlentille 18. Chaque microlentille 18 du capteur d'images 1 est, de préférence, centrée par rapport au carré formé par le pixel auquel elle appartient.

À titre de variante, chaque microlentille 18 peut être remplacée par un autre type d'élément optique de taille micrométrique, notamment une lentille de Fresnel de taille micrométrique, une lentille à gradient d'indice de taille micrométrique ou un réseau de diffraction de taille micrométrique. Les microlentilles 18 sont des lentilles convergentes ayant chacune une distance focale f comprise entre 1 $\mu$m et 100 $\mu$m, de préférence entre 1 $\mu$m et 10 $\mu$m. Selon un mode de réalisation préféré, toutes les microlentilles 18 sont sensiblement identiques, aux dispersions de fabrication près.

Les microlentilles 18 peuvent être réalisées en silice, en polyméthacrylate de méthyle (PMMA), en une résine photosensible positive, en polyéthylène téréphtalate (PET), en polyéthylène naphtalate (PEN), en copolymère cyclo-oléfine (COP), en polydiméthylsiloxane (PDMS)/silicone, ou en résine époxy. Les microlentilles 18 peuvent être formées par fluage de blocs d'une résine photosensible. Les microlentilles 18 peuvent, en outre, être formées par moulage sur une couche de PET, PEN, COP, PDMS/silicone ou résine époxy.

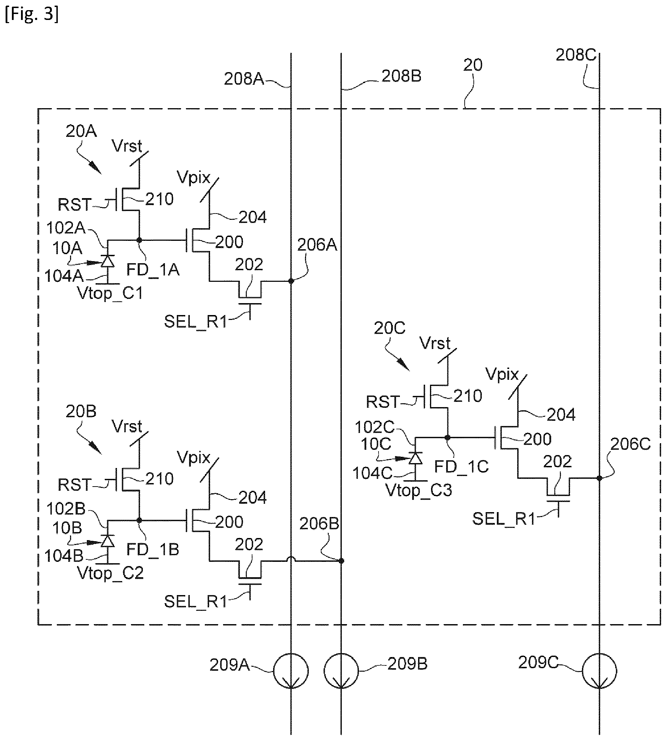

La figure 3 est un schéma électrique d'un mode de réalisation de circuits de lecture du pixel 10 du capteur d'images 1 des figures 1 et 2. En figure 3, on ne s'intéresse, pour simplifier, qu'aux circuits de lecture associés aux photodétecteurs d'un seul pixel du capteur d'images 1, étant entendu que les autres photodétecteurs des autres pixels de ce capteur d'images 1 peuvent posséder des circuits de lecture analogues.

On considère, toujours dans cet exemple, que chaque photodétecteur est associé à son propre circuit de lecture, permettant de le piloter de façon indépendante des autres photodétecteurs. Ainsi, en figure 3 :

    le premier photodétecteur 10A du pixel 10 est associé à un premier circuit de lecture 20A ;
    le deuxième photodétecteur 10B du pixel 10 est associé à un deuxième circuit de lecture 20B ; et
    le troisième photodétecteur 10C du pixel 10 est associé à un troisième circuit de lecture 20C. Ces trois circuits de lecture 20A, 20B, 20C forment conjointement un circuit de lecture 20 du pixel 10.

Chaque circuit de lecture 20A, 20B, 20C comprend, dans cet exemple, trois transistors MOS. Un tel circuit est couramment désigné, avec son photodétecteur, par l'expression « capteur 3T ». En particulier, dans l'exemple de la figure 3 :

    le premier circuit de lecture 20A, associé au premier photodétecteur 10A, comporte un transistor MOS en montage suiveur 200, en série avec un transistor MOS de sélection 202, entre deux bornes 204 et 206A ;
    le deuxième circuit de lecture 20B, associé au deuxième photodétecteur 10B, comporte un transistor MOS en montage suiveur 200, en série avec un transistor MOS de sélection 202, entre deux bornes 204 et 206B ; et
    le troisième circuit de lecture 20C, associé au troisième photodétecteur 10C, comporte un transistor MOS en montage suiveur 200, en série avec un transistor MOS de sélection 202, entre deux bornes 204 et 206C.

Chaque borne 204 est reliée à une source d'un potentiel de référence haut, noté Vpix, dans le cas où les transistors des circuits de lecture sont des transistors MOS à canal N. Chaque borne 204 est reliée à une source d'un potentiel de référence bas, par exemple la masse, dans le cas où les transistors des circuits de lecture sont des transistors MOS à canal P.

La borne 206A est reliée à une première piste conductrice 208A. La première piste conductrice 208A peut être reliée à tous les premiers photodétecteurs des pixels d'une même colonne. La première piste conductrice 208A est, de préférence, reliée à tous les premiers photodétecteurs du capteur d'images 1.

De façon analogue, la borne 206B, respectivement 206C, est reliée à une deuxième piste conductrice 208B, respectivement à une troisième piste 208C. La deuxième piste 208B, respectivement la troisième piste 208C, peut être reliée à tous les deuxièmes photodétecteurs, respectivement à tous les troisièmes photodétecteurs, des pixels d'une même colonne. Cette piste 208B, respectivement 208C, est, de préférence, reliée à tous les deuxièmes photodétecteurs, respectivement à tous les troisièmes photodétecteurs, du capteur d'images 1. La première piste conductrice 208A, la deuxième piste conductrice 208B et la troisième piste conductrice 208C sont, de préférence, distinctes les unes des autres.

Dans le mode de réalisation de la figure 3 :

    la première piste conductrice 208A est reliée, de préférence connectée, à une première source de courant 209A ;
    la deuxième piste conductrice 208B est reliée, de préférence connectée, à une deuxième source de courant 209B ; et
    la troisième piste conductrice 208C est reliée, de préférence connectée, à une troisième source de courant 209C.

Les sources de courant 209A, 209B et 209C ne font pas partie du circuit de lecture 20 du pixel 10 du capteur d'images 1. En d'autres termes, ces sources de courant 209A, 209B et 209C du capteur d'images 1 sont externes aux pixels et circuits de lecture.

La grille des transistors 202 du circuit de lecture du pixel 10 est destinée à recevoir un signal, noté SEL_R1, de sélection du pixel 10. On suppose que la grille des transistors 202 du circuit de lecture d'un autre pixel du capteur d'images 1, par exemple, le circuit de lecture du pixel 12, est destinée à recevoir un autre signal, noté SEL_R2, de sélection de ce pixel 12.

Dans l'exemple de la figure 3 :

la grille du transistor 200 associé au premier photodétecteur 10A du pixel 10 est reliée à un nœud FD_1A ;
la grille du transistor 200 associé au deuxième photodétecteur 10B du pixel 10 est reliée à un nœud FD_1B ; et
la grille du transistor 200 associé au troisième photodétecteur 10C du pixel 10 est reliée à un nœud FD_1C.

Chaque nœud FD_1A, FD_1B, FD_1C est relié, par un transistor MOS 210 de réinitialisation, à une borne d'application d'un potentiel Vrst de réinitialisation, ce potentiel pouvant être identique au potentiel Vpix. La grille du transistor 210 est destinée à recevoir un signal RST de commande de réinitialisation du photodétecteur, permettant notamment de réinitialiser le nœud FD_1A, FD_1B ou FD_1C sensiblement au potentiel Vrst.

Dans l'exemple de la figure 3 :

le nœud FD_1A est connecté à une électrode de cathode 102A du premier photodétecteur 10A du pixel 10 ;
le nœud FD_1B est connecté à une électrode de cathode 102B du deuxième photodétecteur 10B du pixel 10 ; et
le nœud FD_1C est connecté à une électrode de cathode 102C du troisième photodétecteur 10C du pixel 10.

Toujours dans l'exemple de la figure 3 :

une électrode d'anode 104A du premier photodétecteur 10A du pixel 10 est reliée à une source d'un potentiel de référence Vtop_Cl ;
une électrode d'anode 104B du deuxième photodétecteur 10B du pixel 10 est reliée à une source d'un potentiel de référence Vtop_C2 ; et
une électrode d'anode 104C du troisième photodétecteur 10C du pixel 10 est reliée à une source du potentiel de référence Vtop_C3.

Dans le capteur d'images 1, le potentiel Vtop_Cl est, par exemple, appliqué sur une première électrode supérieure commune à tous les premiers photodétecteurs de ce capteur d'images 1. De façon analogue, le potentiel Vtop_C2, respectivement Vtop_C3, est appliqué sur une deuxième électrode supérieure commune à tous les deuxièmes photodétecteurs, respectivement sur une troisième électrode commune à tous les troisièmes photodétecteurs, du capteur d'images 1.

Dans la suite de la description, on note arbitrairement :

VFD_1A la tension présente au nœud FD_1A ;
VFD_1B la tension présente au nœud FD_1B ;
VSEL_R1 la tension appliquée sur la grille des transistors 202 du circuit de lecture 20 du pixel 10, c'est-à-dire la tension appliquée sur la grille du transistor 202 du premier photodétecteur 10A, du deuxième photodétecteur 10B et du troisième photodétecteur 10C ; et
VSEL_R2 la tension appliquée sur la grille des transistors 202 du circuit de lecture du pixel 12.

On considère dans la suite de la description que l'application de la tension VSEL_R1, respectivement VSEL_R2, est commandée par le signal binaire noté SEL_R1, respectivement SEL_R2.

On connaît d'autres types de capteurs, par exemple des capteurs dits « 4T ». L'utilisation de photodétecteurs organiques permet avantageusement d'économiser un transistor et d'utiliser un capteur 3T.

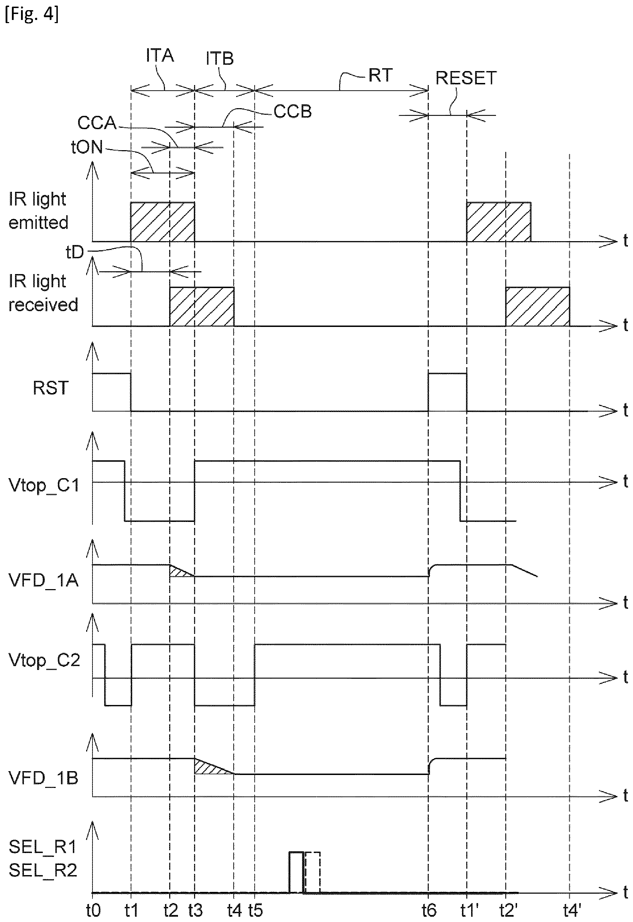

La figure 4 est un chronogramme de signaux d'un exemple de fonctionnement du capteur d'images 1 ayant les circuits de lecture de la figure 3.

Le chronogramme de la figure 4 correspond, plus particulièrement, à un exemple de fonctionnement du capteur d'images 1 en mode « temps de vol » (Time of Flight - ToF). Dans ce mode de fonctionnement, les pixels du capteur d'images 1 sont utilisés pour évaluer une distance les séparant d'un sujet (objet, scène, visage, etc.) placé ou situé en vis-à-vis de ce capteur d'images 1. Pour évaluer cette distance, on commence par émettre une impulsion lumineuse en direction du sujet avec un système émetteur associé non décrit dans ce texte. Cette impulsion lumineuse est généralement obtenue en illuminant brièvement le sujet par un rayonnement provenant d'une source, par exemple un rayonnement infrarouge proche issu d'une diode électroluminescente. Cette impulsion lumineuse est ensuite au moins partiellement réfléchie par le sujet, puis captée par le capteur d'images 1. On calcule ou on mesure alors une durée mise par l'impulsion lumineuse pour parcourir un aller-retour entre la source et le sujet. Le capteur d'images 1 étant avantageusement situé à proximité de la source, cette durée correspond environ au double de la durée mise par l'impulsion lumineuse pour parcourir la distance séparant le sujet de ce capteur d'images 1.

Le chronogramme de la figure 4 illustre un exemple d'évolution des signaux binaires RST et SEL_R1 ainsi que des potentiels Vtop_C1, Vtop_C2, VFD_1A et VFD_1B du premier photodétecteur 10A et du deuxième photodétecteur 10B du pixel 10. La figure 4 représente aussi, en trait pointillé, le signal binaire de sélection SEL_R2 du pixel 12. Le chronogramme de la figure 4 a été établi en considérant que les transistors MOS du circuit de lecture 20 du pixel 10 sont des transistors à canal N. Le pilotage des troisièmes photodétecteurs des pixels du capteur d'images 1 n'est, pour simplifier, pas détaillé en figure 4.

À un instant t0, le signal SEL_R1 est à l'état bas, de sorte que les transistors 202 du pixel 10 sont bloqués. On entame alors une phase de réinitialisation. Dans ce but, le signal RST est maintenu à l'état haut, de sorte que les transistors de réinitialisation 210 du pixel 10 soient passants. Les charges accumulées dans les photodiodes 10A et 10B sont alors évacuées vers la source du potentiel Vrst.

Le potentiel Vtop_CI est, toujours à l'instant t0, à un niveau haut. Ce niveau haut correspond à une polarisation du premier photodétecteur 10A sous une tension supérieure à une tension résultant de l'application d'un potentiel appelé « potentiel intrinsèque » (built-in potential). Ce potentiel intrinsèque équivaut à une différence entre un travail de sortie de l'anode et un travail de sortie de la cathode. Lorsque le potentiel Vtop_CI est au niveau haut, le premier photodétecteur 10A n'intègre pas de charges.

Avant un instant t1, postérieur à l'instant t0, le potentiel Vtop_C1 est mis à un niveau bas. Ce niveau bas correspond à une polarisation du premier photodétecteur 10A sous une tension négative, c'est-à-dire inférieure à 0 V. Cela permet ainsi au premier photodétecteur 10A d'intégrer des charges photogénérées. Ce qui a été décrit précédemment en relation avec la polarisation du premier photodétecteur 10A par le potentiel Vtop_CI se transpose à l'explication du fonctionnement de la polarisation du deuxième photodétecteur 10B par le potentiel Vtop_C2.

À l'instant t1, on commence à émettre une première impulsion lumineuse infrarouge (IR light emitted) vers une scène comprenant un ou des objets dont on souhaite mesurer l'éloignement, ce qui permet d'acquérir une carte de profondeur de la scène. Cette première impulsion lumineuse infrarouge est d'une durée notée tON. À cet instant t1, le signal RST est mis à l'état bas, de sorte que les transistors de réinitialisation 210 du pixel 10 soient bloqués, et le potentiel Vtop_C2 est mis à un niveau haut.

Le potentiel Vtop_CI étant au niveau bas, on entame ainsi, à l'instant t1, une première phase d'intégration, notée ITA, dans le premier photodétecteur 10A du pixel 10 du capteur d'images 1. On désigne par phase d'intégration d'un pixel la phase pendant laquelle le pixel collecte des charges sous l'effet d'un rayonnement incident.

À un instant t2, postérieur à l'instant t1 et séparé de cet instant t1 par une durée notée tD, on commence à recevoir une deuxième impulsion lumineuse infrarouge (IR light received) issue de la réflexion de la première impulsion lumineuse infrarouge par un objet dans la scène, ou par un point d'un objet, dont on souhaite mesurer l'éloignement par rapport au pixel 10. La durée tD est donc fonction de la distance de l'objet au capteur 1. On entame alors une première phase de collection de charges, notée CCA, dans le premier photodétecteur 10A. Cette première phase de collection de charges correspond à une période pendant laquelle des charges sont générées proportionnellement à l'intensité de la lumière incidente, c'est-à-dire proportionnellement à l'intensité lumineuse de la deuxième impulsion, dans le photodétecteur 10A. La première phase de collection de charges provoque une baisse du niveau du potentiel VFD_1A au nœud FD_1A du circuit de lecture 20A.

À un instant t3, dans cet exemple postérieur à l'instant t2 et séparé de l'instant t1 par la durée tON, la première impulsion de lumière infrarouge cesse d'être émise. Le potentiel Vtop_CI est simultanément mis au niveau haut, marquant ainsi la fin de la première phase d'intégration, donc de la première phase de collection de charges.

Dans un même temps, le potentiel Vtop_C2 est mis à un niveau bas. On entame ainsi, à l'instant t3, une deuxième phase d'intégration, notée ITB, dans le deuxième photodétecteur 10B du pixel 10 du capteur d'images 1. Étant donné que le deuxième photodétecteur 10B reçoit de la lumière issue de la deuxième impulsion lumineuse, on débute, toujours à l'instant t3, une deuxième phase de collection de charges, notée CCB. La deuxième phase de collection de charges provoque une baisse du niveau du potentiel VFD_1B au nœud FD_1B du circuit de lecture 20B.

À un instant t4, postérieur à l'instant t3 et séparé de l'instant t2 par une durée sensiblement égale à tON, la deuxième impulsion lumineuse cesse d'être captée par le deuxième photodétecteur 10B du pixel 10. La deuxième phase de collection de charges s'achève donc à cet instant t4.

À un instant t5, postérieur à l'instant t4, le potentiel Vtop_C2 est mis au niveau haut. Cela marque ainsi la fin de la deuxième phase d'intégration.

Entre l'instant t5 et un instant t6, postérieur à l'instant t5, on effectue une phase de lecture, notée RT, pendant laquelle une mesure de la quantité de charges collectée par les photodiodes des pixels du capteur d'images 1 est réalisée. Pour ce faire, on vient par exemple lire de façon séquentielle les lignes de pixels du capteur d'images 1. Dans l'exemple de la figure 4, les signaux SEL_R1 et SEL_R2 sont successivement mis à l'état haut pour venir lire alternativement les pixels 10 et 12 du capteur d'images 1.

Depuis l'instant t6 et jusqu'à un instant t1', postérieur à l'instant t6, on entame une nouvelle phase de réinitialisation (RESET). Le signal RST est mis à l'état haut de sorte que les transistors de réinitialisation 210 du pixel 10 soient passants. Les charges accumulées dans les photodiodes 10A et 10B sont alors évacuées vers la source du potentiel Vrst.

On calcule la durée tD, qui sépare le début de la première impulsion lumineuse émise du début de la deuxième impulsion lumineuse reçue, à l'aide de la formule suivante :

[Math 1]

$$tD = \frac{tON \times \Delta VFD\_1B}{\Delta VFD\_1A + \Delta VFD\_1B}$$

Dans la formule ci-dessus, la grandeur notée $\Delta VFD\_1A$ correspond à une chute du potentiel VFD_1A durant la phase d'intégration du premier photodétecteur 10A. De façon analogue, la grandeur notée $\Delta VFD\_1B$ correspond à une chute du potentiel VFD_1B durant la phase d'intégration du deuxième photodétecteur 10B.

À l'instant t1', on débute une nouvelle évaluation de distance par l'émission d'une deuxième impulsion lumineuse. Cette nouvelle évaluation de distance comporte des instants t2' et t4' semblables aux instants t2 et t4, respectivement.

Le fonctionnement du capteur d'images 1 a été illustré ci-dessus en relation avec un exemple de fonctionnement en mode temps de vol, dans lequel les premier et deuxième photodétecteurs d'un même pixel sont pilotés de façon désynchronisée. Un avantage du capteur d'images 1 est qu'il peut également fonctionner dans d'autres modes, notamment des modes dans lesquels les premier et deuxième photodétecteurs d'un même pixel sont pilotés de façon synchronisée. Le capteur d'images 1 peut, par exemple, être piloté en mode obturateur global (global shutter), c'est-à-dire que ce capteur d'images 1 peut également mettre en œuvre un procédé d'acquisition d'images dans lequel les débuts et fins des phases d'intégration des premier et deuxième photodétecteurs sont simultanés.

Un avantage du capteur d'images 1 est donc de pouvoir fonctionner alternativement selon différents modes. Le capteur d'images 1 peut, par exemple, fonctionner alternativement en mode temps de vol et en mode d'imagerie à obturateur global.

Selon un mode de mise en œuvre, les circuits de lecture des premiers et deuxièmes photodétecteurs du capteur d'images 1 sont pilotés alternativement dans d'autres modes de fonctionnement, par exemple des modes où le capteur d'images 1 est adapté à fonctionner :

    dans une partie du spectre infrarouge ;
    en lumière structurée ;
    en imagerie à grande gamme dynamique (High Dynamic Range - HDR), en faisant par exemple en sorte que, pour chaque pixel, la durée d'intégration du premier photodétecteur soit supérieure à celle du deuxième photodétecteur ; et/ou
    avec suppression de fond.

Le capteur d'images 1 peut ainsi être utilisé pour effectuer différents types d'images sans perte de résolution, car les différents modes d'imagerie pouvant être mis en œuvre par ce capteur d'images 1 exploitent un même nombre de pixels. L'utilisation du capteur d'images 1, capable d'intégrer plusieurs fonctionnalités dans une même matrice de pixels et de circuits de lecture, permet notamment de répondre aux contraintes actuelles de miniaturisation des dispositifs électroniques, par exemple des contraintes de conception et de fabrication de téléphones intelligents (smartphones).

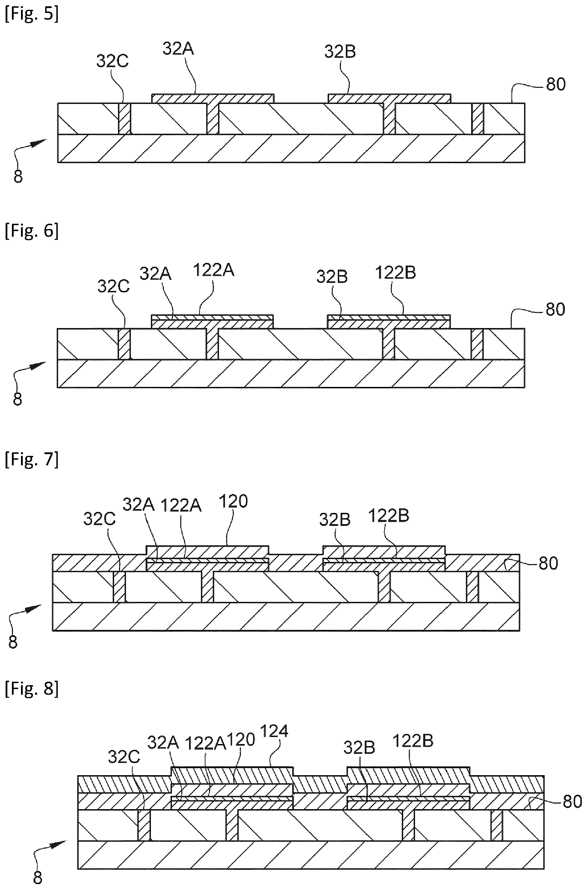

Les figures 5 à 15 ci-dessous illustrent des étapes successives d'un mode de mise en œuvre d'un procédé de réalisation du capteur d'images 1 des figures 1 et 2. Pour simplifier, ce qui est exposé ci-dessous en relation avec les figures 5 à 15 illustre la réalisation d'un pixel du capteur d'images 1, par exemple le pixel 12 du capteur d'images 1. Néanmoins, il est entendu que ce procédé peut être étendu à la réalisation d'un nombre quelconque de photodétecteurs et de pixels d'un capteur d'images analogue au capteur d'images 1.

Selon ce mode de mise en œuvre, on réalise d'abord le premier photodétecteur 12A et le deuxième photodétecteur 12B du pixel 12. On procède ensuite à la réalisation du troisième photodétecteur 12C du pixel 12. La transposition de ce mode de mise en œuvre à la réalisation de l'intégralité des pixels du capteur d'images 1 reviendrait donc à réaliser d'abord la première matrice 2 de premiers et deuxièmes photodétecteurs, puis la deuxième matrice 4 de troisièmes photodétecteurs.

La figure 5 est une vue en coupe, schématique et partielle, d'une étape d'un mode de mise en œuvre d'un procédé de réalisation du capteur d'images 1 des figures 1 et 2.

Selon ce mode de mise en œuvre, on commence par prévoir le support CMOS 8 comportant notamment les circuits de lecture (non représentés) du pixel 12. Ce support CMOS 8 comporte en outre, en surface supérieure 80, des premiers éléments de reprise de contact 32A et 32B ainsi qu'un deuxième élément de reprise de contact 32C. Les premiers éléments de reprise de contact 32A et 32B présentent, vus en coupe en figure 5, une forme de « T » dont :

    une partie horizontale s'étend en surface supérieure 80 du support CMOS 8 ; et
    une partie verticale s'étend vers le bas depuis la surface supérieure 80 du support CMOS 8 pour venir contacter des niveaux de métallisation inférieurs (non représentés) du support CMOS 8 reliés ou connectés aux circuits de lecture (non représentés).

Les premiers éléments de reprise de contact 32A et 32B sont, par exemple, réalisés à partir de pistes conductrices formées en surface supérieure 80 du support CMOS 8 (parties horizontales des premiers éléments de reprise de contact 32A et 32B) et de vias conducteurs (parties verticales des premiers éléments de reprise de contact 32A et 32B) contactant ces pistes conductrices. Le deuxième élément de reprise de contact 32C est, par exemple, réalisé à partir d'un via conducteur affleurant en surface supérieure 80 du support CMOS 8. En variante, le deuxième élément de reprise de contact 32C possède également une forme de « T ». Ce deuxième élément de reprise de contact 32C possède, le cas échéant, des dimensions inférieures à celles des premiers éléments de reprise de contact 32A et 32B. Les dimensions du deuxième élément de reprise de contact 32C sont alors ajustées pour ne pas perturber la disposition des premiers éléments de reprise de contact 32A et 32B tout en offrant une surface de connexion maximale.

Les pistes conductrices et les vias conducteurs peuvent être en un matériau métallique, par exemple l'argent (Ag), l'aluminium (Al), l'or (Au), le cuivre (Cu), le nickel (Ni), le titane (Ti) et le chrome (Cr), ou en nitrure de titane (TiN). Les pistes conductrices et les vias conducteurs peuvent avoir une structure monocouche ou multicouche. Dans le cas où les pistes conductrices possèdent une structure multicouche, ces pistes conductrices peuvent être constituées d'un empilement de couches conductrices séparées par des couches isolantes. Les vias traversent alors ces couches isolantes. Les couches conductrices peuvent être en un matériau métallique de la liste ci-dessus et les couches isolantes peuvent être en nitrure de silicium (SiN) ou en oxyde de silicium (SiO$_2$).

Lors de cette même étape, on procède à un nettoyage du support CMOS 8 afin de retirer d'éventuelles impuretés se trouvant à sa surface 80. Ce nettoyage s'effectue, par exemple, par plasma. Le nettoyage permet ainsi d'obtenir une propreté satisfaisante du support CMOS 8 avant d'effectuer une série de dépôts successifs, détaillés en relation avec les figures ci-dessous.

Dans la suite de la description, le mode de mise en œuvre du procédé décrit en relation avec les figures 6 à 15 consiste exclusivement à réaliser des opérations au-dessus de la surface supérieure 80 du support CMOS 8. Le support CMOS 8 des figures 6 à 15 est donc, de préférence, identique au support CMOS 8 tel qu'exposé en relation avec la figure 5 pendant tout le procédé. Pour simplifier, le support CMOS 8 ne sera donc pas à nouveau détaillé dans les figures ci-dessous.

La figure 6 est une vue en coupe, schématique et partielle, d'une autre étape du mode de mise en œuvre du procédé de réalisation du capteur d'images 1 des figures 1 et 2 à partir de la structure telle que décrite en relation avec la figure 5.

Au cours de cette étape, on procède à un dépôt, en surface des premiers éléments de reprise de contact 32A et 32B, d'un matériau injecteur d'électrons. On dépose, de préférence, un matériau s'attachant ou se liant sélectivement en surface des éléments de reprise de contact 32A et 32B pour constituer une monocouche auto-assemblée (Self-Assembled Monolayer - SAM). Ce dépôt recouvre ainsi partiellement ou uniquement les surfaces supérieures libres des premiers éléments de reprise de contact 32A et 32B. On forme donc, comme illustré en figure 6 :

une électrode inférieure 122A du premier photodétecteur organique 12A du pixel 12 ; et
une électrode inférieure 122B du deuxième photodétecteur organique 12B du pixel 12.

En variante, on procède à un dépôt pleine plaque d'un matériau injecteur d'électrons possédant une conductivité latérale suffisamment faible pour ne pas créer de chemins de conduction entre deux éléments de reprise de contact voisins.

Les électrodes inférieures 122A et 122B constituent des couches d'injection d'électrons (Electron Injection Layer - EIL) des photodétecteurs 12A et 12B, respectivement. Ces électrodes inférieures 122A et 122B constituent, par exemple, les cathodes des photodétecteurs 12A et 12B du capteur d'images 1. Les électrodes inférieures 122A et 122B sont, de préférence, réalisées par enduction centrifuge à la tournette (spin coating) ou par enduction par trempage (dip coating).

Le matériau composant les électrodes inférieures 122A et 122B est choisi parmi le groupe comprenant :

un métal ou un alliage métallique, par exemple de l'argent (Ag), de l'aluminium (Al), du plomb (Pb), du palladium (Pd), de l'or (Au), du cuivre (Cu), du nickel (Ni), du tungstène (W), du molybdène (Mo), du titane (Ti) ou du chrome (Cr) ou un alliage de magnésium et d'argent (MgAg) ;
un oxyde conducteur transparent (Transparent Conductive Oxide - TCO), notamment de l'oxyde d'indium dopé à l'étain (Indium Tin Oxide - ITO), un oxyde de zinc et d'aluminium (Aluminium Zinc Oxide - AZO), un oxyde de gallium et de zinc (Gallium Zinc Oxide - GZO), un multicouche ITO/Ag/ITO, un multicouche ITO/Mo/ITO, un multicouche AZO/Ag/AZO ou un multicouche ZnO/Ag/ZnO ;
un polymère de polyéthylèneimine (PEI) ou un polymère de polyéthylèneimine éthoxylée (PEIE), propoxylée et/ou butoxylée ;
des nanofils de carbone, d'argent et/ou de cuivre ;
du graphène ; et
un mélange d'au moins deux de ces matériaux.

Les électrodes inférieures 122A et 122B peuvent avoir une structure monocouche ou multicouche.

La figure 7 est une vue en coupe, schématique et partielle, d'encore une autre étape du mode de mise en œuvre du procédé de réalisation du capteur d'images 1 des figures 1 et 2 à partir de la structure telle que décrite en relation avec la figure 6.

Au cours de cette étape, on procède à un dépôt non sélectif d'une première couche 120 du côté de la surface supérieure 80 du support CMOS 8. Ce dépôt est qualifié de dépôt « pleine plaque » car il recouvre la totalité de la surface supérieure 80 du support CMOS 8 ainsi que les surfaces libres des premiers éléments de reprise de contact 32A et 32B, du deuxième élément de reprise de contact 32C et des électrodes inférieures 122A et 122B. Selon ce mode de mise en œuvre, la première couche 120 est destinée à former des couches actives du premier photodétecteur 12A et du deuxième photodétecteur 12B du pixel 12. Le dépôt de la première couche 120 est, de préférence, réalisé par enduction centrifuge à la tournette.

La première couche 120 peut comprendre des petites molécules, des oligomères ou des polymères. Il peut s'agir de matériaux organiques ou inorganiques, notamment comprenant des boîtes quantiques. La première couche 120 peut comprendre un matériau semiconducteur ambipolaire, ou un mélange d'un matériau semiconducteur de type N et d'un matériau semiconducteur de type P, par exemple sous forme de couches superposées ou d'un mélange intime à l'échelle nanométrique de façon à former une hétérojonction en volume. L'épaisseur de la première couche 120 peut être comprise entre 50 nm et 2 $\mu$m, par exemple de l'ordre de 300 nm.

Des exemples de polymères semiconducteurs de type P adaptés à la réalisation de la couche 120 sont :

le poly(3-hexylthiophène) (P3HT) ;
le poly[N-9'-heptadécanyl-2,7-carbazole-alt-5,5-(4,7-di-2-thiényl-2',1',3'-benzothiadiazole)] (PCDTBT) ;
le poly[(4,8-bis-(2-éthylhexyloxy)-benzo[1,2-b;4,5-b'] dithiophène)-2,6-diyl-alt-(4-(2-éthylhexanoyl)-thieno[3,4-b] thiophène))-2,6-diyl] (PBDTTT-C) ;
le poly[2-méthoxy-5-(2-éthyl-hexyloxy)-1,4-phénylène-vinylène] (MEH-PPV) ; et
le poly[2,6-(4,4-bis-(2-éthylhexyl)-4H-cyclopenta [2,1-$b$;3,4-$b$']dithiophène)-$alt$-4,7(2,1,3-benzothiadiazole)] (PCPDTBT).

Des exemples de matériaux semiconducteurs de type N adaptés à la réalisation de la couche 120 sont les fullerènes, notamment le C60, le [6,6]-phényl-$C_{61}$-butanoate de méthyle ([60]PCBM), le [6,6]-phényl-$C_{71}$-butanoate de méthyle ([70]PCBM), le pérylène diimide, l'oxyde de zinc (ZnO) ou des nanocristaux permettant la formation de boîtes quantiques (quantum dots).

La figure 8 est une vue en coupe, schématique et partielle, d'encore une autre étape du mode de mise en œuvre du procédé de réalisation du capteur d'images 1 des figures 1 et 2 à partir de la structure telle que décrite en relation avec la figure 7.

Au cours de cette étape, on procède à un dépôt non sélectif (dépôt pleine plaque) d'une deuxième couche 124 du côté de la surface supérieure 80 du support CMOS 8. Ce dépôt recouvre ainsi la totalité de la surface supérieure de la première couche 120. Selon ce mode de mise en œuvre, la deuxième couche 124 est destinée à former des électrodes supérieures du premier photodétecteur 12A et du deuxième photodétecteur 12B du pixel 12. Le dépôt de la deuxième couche 124 est, de préférence, effectué par enduction centrifuge à la tournette.

La deuxième couche 124 est au moins partiellement transparente au rayonnement lumineux qu'elle reçoit. La deuxième couche 124 peut être en un matériau conducteur et transparent, par exemple en oxyde conducteur et transparent (Transparent Conductive Oxide - TCO), en nanotubes de carbone, en graphène, en un polymère conducteur, en un métal, ou en un mélange ou un alliage d'au moins deux de ces composés. La deuxième couche 124 peut avoir une structure monocouche ou multicouche.

Des exemples de TCO adaptés à la réalisation de la deuxième couche 124 sont l'oxyde d'indium-étain (Indium Tin Oxide - ITO), l'oxyde d'aluminium-zinc (Aluminium Zinc Oxide - AZO), l'oxyde de gallium-zinc (Gallium Zinc Oxide - GZO), le nitrure de titane (TiN), l'oxyde de molybdène ($MoO_3$) et l'oxyde de tungstène ($WO_3$) . Un exemple de polymère conducteur adapté à la réalisation de la deuxième couche 124 est le polymère connu sous la dénomination PEDOT:PSS, qui est un mélange de poly(3,4)-éthylènedioxythiophène et de polystyrène sulfonate de sodium et la polyaniline, également appelé PAni. Des exemples de métaux adaptés à la réalisation de la deuxième couche 124 sont l'argent, l'aluminium, l'or, le cuivre, le nickel, le titane et le chrome. Un exemple de structure multicouche adaptée à la réalisation de la deuxième couche 124 est une structure multicouche d'AZO et d'argent de type AZO/Ag/AZO.

L'épaisseur de la deuxième couche 124 peut être comprise entre 10 nm et 5 $\mu$m, par exemple de l'ordre de 60 nm. Dans le cas où la deuxième couche 124 est métallique, l'épaisseur de cette deuxième couche 124 est inférieure ou égale à 20 nm, de préférence inférieure ou égale à 10 nm.

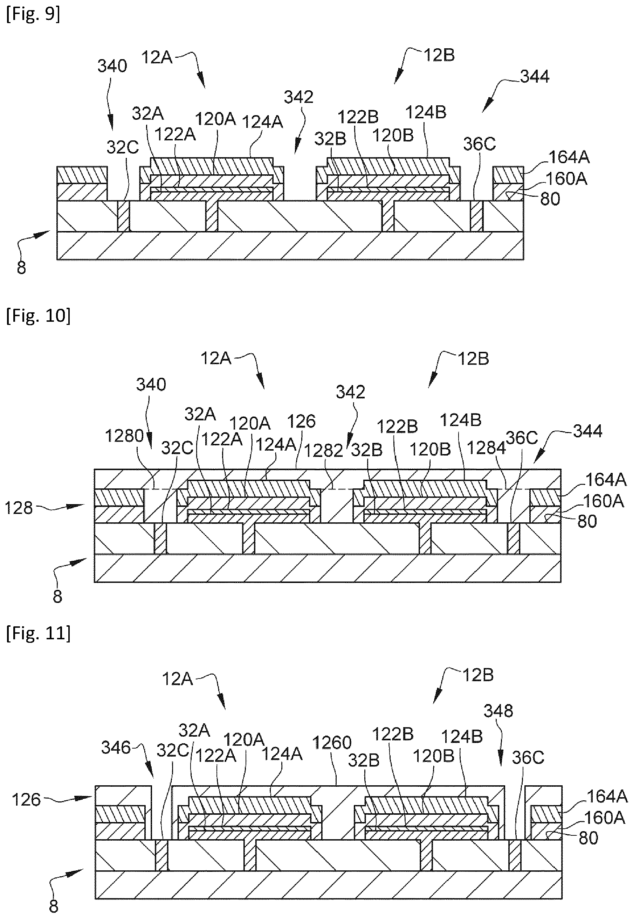

La figure 9 est une vue en coupe, schématique et partielle, d'encore une autre étape du mode de mise en œuvre du procédé de réalisation du capteur d'images 1 des figures 1 et 2 à partir de la structure telle que décrite en relation avec la figure 8.

Au cours de cette étape, on pratique une première ouverture verticale 340, une deuxième ouverture verticale 342 et une troisième ouverture verticale 344, à travers la deuxième couche 124 et à travers la première couche 120, jusqu'à la surface supérieure 80 du support CMOS 8. Dans l'exemple de la figure 9 :

la première ouverture verticale 340 et la deuxième ouverture verticale 342 sont situées de part et d'autre du premier élément de reprise de contact 32A (respectivement à gauche et à droite du premier élément de reprise de contact 32A) ; et
la deuxième ouverture verticale 342 et la troisième ouverture verticale 344 sont situées de part et d'autre du deuxième élément de reprise de contact 32B (respectivement à gauche et à droite du deuxième élément de reprise de contact 32B) .

Ces trois ouvertures verticales 340, 342 et 344 ont notamment pour but de séparer des photodétecteurs appartenant à une même ligne du capteur d'images 1. La première ouverture verticale 340 permet, en outre, de mettre à nu la surface supérieure du deuxième élément de reprise de contact 32C. De façon analogue, la troisième ouverture 344 permet de mettre à nu la surface supérieure d'un troisième élément de reprise de contact 36C semblable au deuxième élément de reprise de contact 32C. Les ouvertures 340, 342 et 344 sont, par exemple, réalisées grâce à des étapes successives de dépôt de photorésine, d'exposition à une lumière ultraviolette à travers un masque (photolithographie) et de gravure physique, par exemple par gravure ionique réactive (Reactive Ion Etching - RIE).

On obtient ainsi, comme illustré en figure 9 :

une couche active 120A du premier photodétecteur 12A du pixel 12, qui recouvre entièrement les faces libres du premier élément de reprise de contact 32A et l'électrode inférieure 122A ;
une couche active 120B du deuxième photodétecteur 12B du pixel 12, qui recouvre entièrement les faces libres du deuxième élément de reprise de contact 32B et l'électrode inférieure 122B ;
une électrode supérieure 124A du premier photodétecteur 12A du pixel 12, recouvrant la couche active 120A ; et
une électrode supérieure 124B du deuxième photodétecteur 12B du pixel 12, recouvrant la couche active 120B.

Ainsi, toujours dans l'exemple de la figure 9 :

l'ouverture 340 est intercalée entre, d'une part, la couche active 120A et l'électrode supérieure 124A du premier photodétecteur 12A du pixel 12 et, d'autre part, une couche active et une électrode supérieure d'un deuxième photodétecteur appartenant à un pixel voisin (non représenté) ;
l'ouverture 342 est intercalée entre, d'une part, la couche active 120A et l'électrode supérieure 124A du premier photodétecteur 12A du pixel 12 et, d'autre part, la couche active 120B et l'électrode supérieure 124B du deuxième photodétecteur 12B du pixel 12 ; et
l'ouverture 344 est intercalée entre, d'une part, la couche active 120B et l'électrode supérieure 124B du deuxième photodétecteur 12B du pixel 12 et, d'autre part, une couche active 160A et une électrode supérieure 164A du premier photodétecteur 16A du pixel 16 (partiellement visible en figure 9).

Les électrodes supérieures 124A et 124B constituent des couches d'injection de trous (Hole Injection Layer - HIL) des photodétecteurs 12A et 12B, respectivement. Ces électrodes supérieures 124A et 124B constituent, par exemple, les anodes des photodétecteurs 12A et 12B du capteur d'images 1. Chaque photodétecteur est ainsi constitué, comme illustré en figure 9, d'une couche active intercalée (ou en « sandwich ») entre une électrode inférieure et une électrode supérieure.

La figure 10 est une vue en coupe, schématique et partielle, d'encore une autre étape du mode de mise en œuvre du procédé de réalisation du capteur d'images 1 des figures 1 et 2 à partir de la structure telle que décrite en relation avec la figure 9.

Au cours de cette étape, une troisième couche 126 est déposée sur toute la structure du côté de la surface supérieure 80 du support CMOS 8. Cette troisième couche 126 est, de préférence, une couche dite de « planarisation » permettant d'obtenir une structure présentant une surface supérieure plane avant encapsulation des photodétecteurs.

En figure 10, la troisième couche 126 comble la première ouverture 340, la deuxième ouverture 342 et la troisième ouverture 344. En outre, cette troisième couche 126 recouvre intégralement les empilements respectivement formés par le premier photodétecteur 12A et par le deuxième photodétecteur 12B. En d'autres termes, le premier photodétecteur 12A et le deuxième photodétecteur 12B sont noyés dans cette troisième couche 126 de planarisation.

La troisième couche 126 de planarisation peut être constituée d'un matériau diélectrique à base de polymères. La troisième couche 126 de planarisation peut alternativement contenir un mélange de nitrure de silicium (SiN) et d'oxyde de silicium ($SiO_2$), ce mélange étant obtenu par pulvérisation (sputtering), par dépôt physique par phase vapeur (Physical Vapor Deposition - PVD) ou par dépôt chimique en phase vapeur assisté par plasma (Plasma-Enhanced Chemical Vapor Deposition - PECVD).

La troisième couche 126 de planarisation peut également être réalisée en polymère fluoré, notamment le polymère fluoré connu sous la dénomination commerciale « Cytop » de la société Bellex, en polyvinylpyrrolidone (PVP), en polyméthacrylate de méthyle (PMMA), en polystyrène (PS), en parylène, en polyimide (PI), en acrylonitrile butadiène styrène (ABS), en polydiméthylsiloxane (PDMS), en une résine de photolithographie, en résine époxy, en résine acrylate ou en un mélange d'au moins deux de ces composés.

À titre de variante, le dépôt de la troisième couche 126 peut être précédé d'un dépôt d'une quatrième couche 128 dite de remplissage ou d'isolation. Cette couche de remplissage 128, dont seules des parties 1280, 1282 et 1284 (en trait pointillé) sont visibles en figure 10, possède alors, de préférence, une épaisseur sensiblement égale à celle de l'empilement conjointement formé par la première couche 120 et par la deuxième couche 124. Les parties 1280, 1282 et 1284 comblent respectivement la première ouverture 340, la deuxième ouverture 342 et la troisième ouverture 344. En d'autres termes, la couche de remplissage 128 recouvre dans ce cas, par ses parties 1280, 1282 et 1284, des zones libres de la surface supérieure 80 du support CMOS 8 et affleure sensiblement la surface supérieure de la deuxième couche 124.

Dans le capteur d'images 1, la quatrième couche 128 de remplissage a pour but d'isoler électriquement chaque photodétecteur des photodétecteurs voisins. Selon un mode de mise en œuvre, le matériau de cette couche de remplissage 128 réfléchit, au moins partiellement, la lumière reçue par le capteur d'images 1 afin d'isoler optiquement les photodétecteurs entre eux. La couche de remplissage 128 est alors qualifiée de « résine noire » (black resin).

La couche de remplissage 128 peut être en un matériau inorganique, par exemple en oxyde de silicium ($SiO_2$) ou en nitrure de silicium (SiN).

La couche de remplissage 128 peut être réalisée en polymère fluoré, notamment le polymère fluoré commercialisé sous l'appellation Cytop par la société Bellex, en polyvinylpyrrolidone (PVP), en polyméthacrylate de méthyle (PMMA), en polystyrène (PS), en parylène, en polyimide (PI), en acrylonitrile butadiène styrène (ABS), en polydiméthylsiloxane (PDMS), en une résine de photolithographie, en résine époxy, en résine acrylate ou en un mélange d'au moins deux de ces composés.

La couche de remplissage 128 peut aussi être réalisée en oxyde d'aluminium ($Al_2O_3$). Le cas échéant, l'oxyde d'aluminium peut être déposé par dépôt de couches minces atomiques (Atomic Layer Deposition - ALD). L'épaisseur maximale de la couche de remplissage 128 peut être comprise entre 50 nm et 2 $\mu$m, par exemple de l'ordre de 400 nm.

On suppose, dans la suite de la description, que la variante consistant à déposer, avant la troisième couche 126 de planarisation, la quatrième couche 128 de remplissage n'est pas retenue dans le mode de mise en œuvre du procédé. On considère donc que seule la troisième couche de planarisation a été déposée, cette couche de planarisation 126 remplissant les ouvertures 340, 342 et 344 et recouvrant intégralement les empilements constitues par les photodétecteurs 12A et 12B. Toutefois, l'adaptation des étapes qui suivent à un cas où le dépôt de la troisième couche de planarisation 126 est précédé du dépôt de la quatrième couche de remplissage 128 est à la portée de l'homme du métier à partir des indications fournies ci-dessous.

La figure 11 est une vue en coupe, schématique et partielle, d'encore une autre étape du mode de mise en œuvre du procédé de réalisation du capteur d'images 1 des figures 1 et 2 à partir de la structure telle que décrite en relation avec la figure 10.

Au cours de cette étape, une quatrième ouverture 346 et une cinquième ouverture 348 sont pratiquées dans la troisième couche 126 de planarisation. Cette quatrième ouverture 346 et cette cinquième ouverture 348 sont respectivement localisées à l'aplomb du deuxième élément de reprise de contact 32C et du troisième élément de reprise de contact 36C.

La quatrième ouverture 346 et la cinquième ouverture 348 peuvent être réalisées par photolithographie. À titre de variante, cette quatrième ouverture 346 et cette cinquième ouverture 348 peuvent être réalisées par une technique de décollement (lift-off) consistant à effectuer, par exemple, des opérations successives :

> de dépôt d'une couche sacrificielle de résine, localisée au niveau du deuxième élément de reprise de contact 32C et du troisième élément de reprise de contact 36C, pour constituer des plots de résine ;
> de dépôt de la troisième couche 126 de planarisation ; et
> de décollement des plots de résine pour supprimer des parties de la troisième couche 126 de planarisation localisées à l'aplomb du deuxième élément de reprise de contact 32C et du troisième élément de reprise de contact 36C.

Selon cette variante, le dépôt de la troisième couche 126 de planarisation est, de préférence, effectué de façon directionnelle. Le dépôt de cette troisième couche 126 est, par exemple, réalisé par dépôt chimique en phase vapeur assisté par plasma (PECVD).

La quatrième ouverture 346 et la cinquième ouverture 348 ont pour but de libérer ou dégager respectivement les surfaces supérieures du deuxième élément de reprise de contact 32C et du troisième élément de reprise de contact 36C. Cette quatrième ouverture 346 et cette cinquième ouverture 348 possèdent, de préférence, des dimensions horizontales supérieures à celles du deuxième élément de reprise de contact 32C et du troisième élément de reprise de contact 36C.

La quatrième ouverture 346 et la cinquième ouverture 348 sont situées de part et d'autre du premier photodétecteur 12A et du deuxième photodétecteur 12B du pixel 12 du capteur d'images 1. En figure 11, une partie 1260 de la troisième couche de planarisation 126 recouvre ainsi les empilements formés par le premier photodétecteur 12A et par le deuxième photodétecteur 12B.

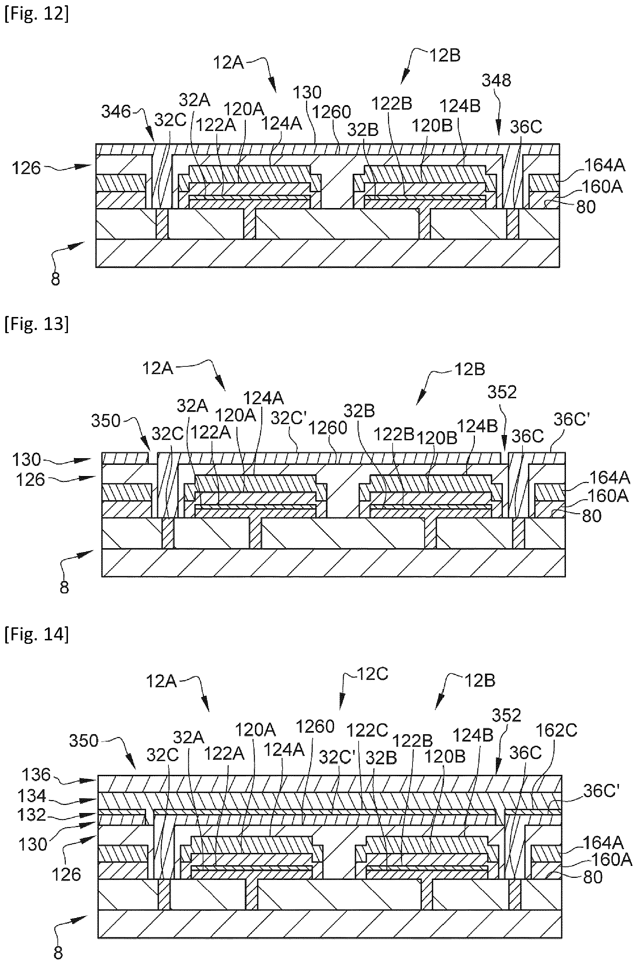

La figure 12 est une vue en coupe, schématique et partielle, d'encore une autre étape du mode de mise en œuvre du procédé de réalisation du capteur d'images 1 des figures 1 et 2 à partir de la structure telle que décrite en relation avec la figure 11.

Au cours de cette étape, une cinquième couche 130 est déposée sur toute la structure du côté de la surface supérieure 80 du support CMOS 8. En figure 12, la cinquième couche 130 comble entièrement la quatrième ouverture 346 et la cinquième ouverture 348. En outre, cette cinquième couche 130 recouvre intégralement la surface supérieure libre des parties de la troisième couche de planarisation 126, en particulier la partie 1260 de cette troisième couche 126.

Selon ce mode de mise en œuvre, la cinquième couche 130 est notamment destinée à former ultérieurement des éléments de reprise de contact des troisièmes photodétecteurs du capteur d'images 1. Cette cinquième couche 130 peut être constituée des mêmes matériaux que ceux exposés en relation avec la figure 8 pour la deuxième couche 124. La cinquième couche 130 est, de préférence, constituée de métal. Dans le cas où la cinquième couche 130 est métallique, l'épaisseur de cette cinquième couche 130 est inférieure ou égale à 20 nm, de préférence inférieure ou égale à 10 nm. Cette cinquième couche 130 est, de préférence, transparente aux rayonnements captés par le futur premier photodétecteur 12A et par le futur deuxième photodétecteur 12B. La cinquième couche 130 est, le cas échéant, constituée d'un oxyde métallique transparent, par exemple l'oxyde d'indium dopé à l'étain (ITO).

La figure 13 est une vue en coupe, schématique et partielle, d'encore une autre étape du mode de mise en œuvre du procédé de réalisation du capteur d'images 1 des figures 1 et 2 à partir de la structure telle que décrite en relation avec la figure 12.

Au cours de cette étape, une sixième ouverture 350 et une septième ouverture 352 sont pratiquées dans la cinquième couche 130 jusqu'à la surface supérieure des parties de la troisième couche 126. En figure 13, cette sixième ouverture 350 et cette septième ouverture 352 délimitent un quatrième élément de reprise de contact 32C' formé dans la cinquième couche 130. Ce quatrième élément de reprise de contact 32C' présente, en figure 13, une forme de « L ». Le quatrième élément de reprise de contact 32C' touche la surface supérieure du deuxième élément de reprise de contact 32C et recouvre partiellement la surface supérieure de la partie 1260 de la troisième couche 126.

Le quatrième élément de reprise de contact 32C' a pour but de prolonger le deuxième élément de reprise de contact 32C en surface de la partie 1260 de la troisième couche 126. Le deuxième élément de reprise de contact 32C et le quatrième élément de reprise de contact 32C' constituent ainsi conjointement un même élément de reprise de contact du troisième photodétecteur 12C du pixel 12 du capteur d'images 1.

De façon analogue, un cinquième élément de reprise de contact 36C', formé dans la cinquième couche 130, prolonge le troisième élément de reprise de contact 36C. Le troisième élément de reprise de contact 36C et le cinquième élément de reprise de contact 36C' constituent ainsi conjointement un même élément de reprise de contact du troisième photodétecteur 16C du pixel 16 du capteur d'images 1. En figure 13, le quatrième élément de reprise de contact 32C' est séparé du cinquième élément de reprise de contact 36C' par la septième ouverture 352.

La sixième ouverture 350 et la septième ouverture 352 sont, de préférence, réalisées par photolithographie. Le quatrième élément de reprise de contact 32C' et le cinquième élément de reprise de contact 36C' sont, de préférence, obtenus par gravure ionique réactive (RIE) ou par gravure à l'aide d'un solvant.

À titre de variante, des plots sacrificiels sont déposés avant de procéder au dépôt de la cinquième couche 130 comme exposé en relation avec la figure 12. Ces plots sont, le cas échéant, disposés aux emplacements de la sixième ouverture 350 et de la septième ouverture 352. On retire alors les plots sacrificiels par décollement (lift-off) pour pratiquer les ouvertures 350 et 352 au cours de l'étape exposée en relation avec la figure 13.

La figure 14 est une vue en coupe, schématique et partielle, d'encore une autre étape du mode de mise en œuvre du procédé de réalisation du capteur d'images 1 des figures 1 et 2 à partir de la structure telle que décrite en relation avec la figure 13.

Au cours de cette étape, on procède à un dépôt, en surface de la cinquième couche 130, d'une sixième couche 132. On dépose, de préférence, un matériau s'attachant ou se liant sélectivement en surface des éléments de reprise de contact 32C' et 36C' pour constituer une monocouche auto-assemblée. On forme ainsi, comme illustré en figure 14 :

l'électrode inférieure 122C, recouvrant la surface supérieure du quatrième élément de reprise de contact 32C', du troisième photodétecteur 12C du pixel 12 ; et

l'électrode inférieure 162C, recouvrant la surface supérieure du cinquième élément de reprise de contact 36C', du troisième photodétecteur 16C du pixel 16.

Les électrodes inférieures 122C et 162C constituent respectivement des couches d'injection d'électrons (Electron Injection Layer - EIL) des troisièmes photodétecteurs 12C et 16C. Ces électrodes inférieures 122C et 162C constituent, par exemple, les cathodes des troisièmes photodétecteurs 12C et 16C du capteur d'images 1.

Les électrodes inférieures 122C et 162C des troisièmes photodétecteurs 12C et 16C peuvent être constituées des mêmes matériaux que les électrodes inférieures 122A et 122B du premier photodétecteur 12A et du deuxième photodétecteur 12B. Les électrodes inférieures 122C et 162C peuvent, en outre, avoir une structure monocouche ou multicouche.

Au cours de cette étape, on procède également à un dépôt non sélectif (dépôt pleine plaque) d'une septième couche 134 du côté de la surface supérieure 80 du support CMOS 8. Cette septième couche 134 comble ainsi la sixième ouverture 350 et la septième ouverture 352 et couvre intégralement l'électrode inférieure 122C du troisième photodétecteur 12C du pixel 12 et l'électrode inférieure 162C du troisième photodétecteur 16C du pixel 16. Selon ce mode de mise en œuvre, la septième couche 134 est destinée à former des couches actives des troisièmes photodétecteurs des pixels du capteur d'images 1.

Selon un mode de mise en œuvre préféré, la composition de la septième couche 134 est différente de celle de la première couche 120. La première couche 120 possède, par exemple, une longueur d'onde d'absorption d'environ 940 nm tandis que la septième couche 134 possède, par exemple, une longueur d'onde d'absorption centrée sur la plage de longueurs d'ondes du domaine visible.

Au cours de cette étape, on procède également à un dépôt non sélectif (dépôt pleine plaque) d'une huitième couche 136 du côté de la surface supérieure 80 du support CMOS 8. Ce dépôt recouvre ainsi la totalité de la surface supérieure de la septième couche 134. Selon ce mode de mise en œuvre, la huitième couche 136 est destinée à former des électrodes supérieures des troisièmes photodétecteurs 12C et 16C des pixels 12 et 16, respectivement.

La huitième couche 136 est au moins partiellement transparente au rayonnement lumineux qu'elle reçoit. La huitième couche 136 peut être en un matériau semblable à celui exposé en relation avec la figure 8 pour la deuxième couche 124.

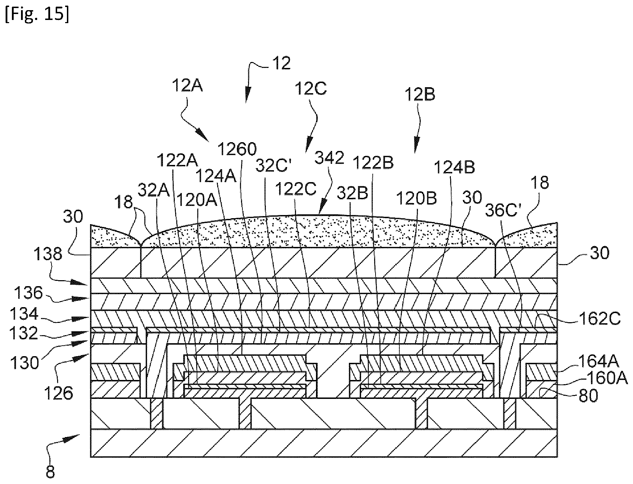

La figure 15 est une vue en coupe, schématique et partielle, d'encore une autre étape du mode de mise en œuvre du procédé de réalisation du capteur d'images 1 des figures 1 et 2 à partir de la structure telle que décrite en relation avec la figure 14.

Au cours de cette étape, on dépose une neuvième couche 138, appelée couche de passivation 138, sur toute la structure du côté de la surface supérieure 80 du support CMOS 8. Cette neuvième couche 138 a pour but d'encapsuler les photodétecteurs organiques du capteur d'images 1. La neuvième couche 138 permet ainsi d'éviter la dégradation, du fait d'une exposition à l'eau ou à l'humidité contenue, par exemple, dans l'air ambiant, des matériaux organiques constitutifs des photodétecteurs du capteur d'images 1. Dans l'exemple de la figure 15, la neuvième couche 138 recouvre la totalité de la surface supérieure de la huitième couche 136.

La couche de passivation 138 peut être constituée d'alumine ($Al_2O_3$) obtenue par un procédé de dépôt par couches minces atomiques (Atomic Layer Deposition - ALD), de nitrure de silicium ($Si_3N_4$) ou d'oxyde de silicium ($SiO_2$) obtenus par dépôt physique par phase vapeur (PVD), de nitrure de silicium obtenu par dépôt chimique en phase vapeur assisté par plasma (PECVD). La couche de passivation 138 peut alternativement être constituée de PET, de PEN, de COP ou de CPI.

Selon un mode de mise en œuvre, la couche de passivation 138 permet d'améliorer encore davantage l'état de surface de la structure avant réalisation des filtres couleur 30 et des microlentilles 18.

Au cours de cette étape, un filtre couleur 30 est réalisé à l'aplomb de l'emplacement de chaque pixel. Plus précisément, en figure 15, un même filtre couleur 30 est réalisé à l'aplomb des trois photodétecteurs 12A, 12B et 12C du pixel 12. En d'autres termes, chaque pixel du capteur d'images 1 possède un unique filtre couleur 30 commun aux premier, deuxième et troisième photodétecteurs du pixel considéré.

Au cours de cette étape, on vient également réaliser la microlentille 18 du pixel 12 à l'aplomb des photodétecteurs 12A, 12B et 12C. Dans l'exemple de la figure 15, cette microlentille 18 est sensiblement centrée par rapport à l'ouverture 342 séparant le premier photodétecteur 12A du deuxième photodétecteur 12B. On obtient ainsi le pixel 12 du capteur d'images 1.

Une microlentille 18 est située à l'aplomb de chaque filtre couleur 30 du capteur d'images 1, de sorte que ce capteur d'images 1 comporte autant de filtres couleur 30 que de microlentilles 18. Les filtres couleur 30 et les microlentilles 18 possèdent, de préférence, des dimensions latérales identiques, de sorte que chaque microlentille 18 d'un pixel donné recouvre entièrement le filtre couleur 30 auquel elle est associée sans pour autant recouvrir les filtres couleur 30 appartenant aux pixels adjacents.

Les filtres couleur 30 sont, de préférence, des filtres centrés sur une couleur du spectre visible (rouge, vert ou bleu) pour permettre une bonne sélectivité de la plage de longueurs d'ondes reçue par le troisième photodétecteur 12C. Ces filtres couleur 30 laissent toutefois passer le rayonnement non absorbé par le troisième photodétecteur 12C mais absorbé par le premier photodétecteur 12A et par le deuxième photodétecteur 12B, par exemple le rayonnement proche infrarouge aux alentours de 940 nm.

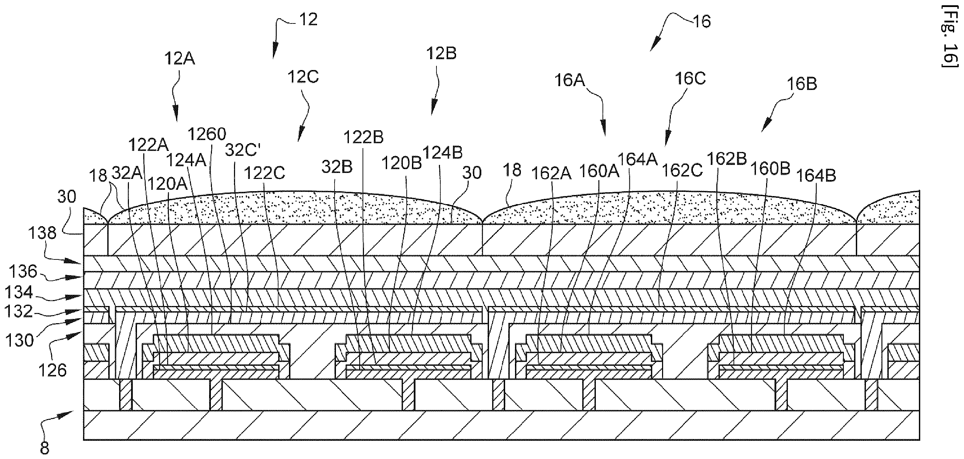

La figure 16 est une vue en coupe selon le plan AA (figure 2), schématique et partielle, du capteur d'images 1 des figures 1 et 2. Le plan de coupe AA correspond à un plan de coupe parallèle à une ligne de pixels du capteur d'images 1.

En figure 16, seuls les pixels 12 et 16 du capteur d'images 1 ont été représentés. Ces pixels 12 et 16 appartiennent à une même ligne de pixels du capteur d'images 1. Dans l'exemple de la figure 16, les premiers photodétecteurs 12A, 16A et les deuxièmes photodétecteurs 12B, 16B des pixels 12 et 16, respectivement, sont séparés les uns des autres. En revanche, toujours dans l'exemple de la figure 16, les troisièmes photodétecteurs 12C, 16C des pixels 12 et 16, respectivement, partagent une même couche active 134 et une même électrode supérieure 136.

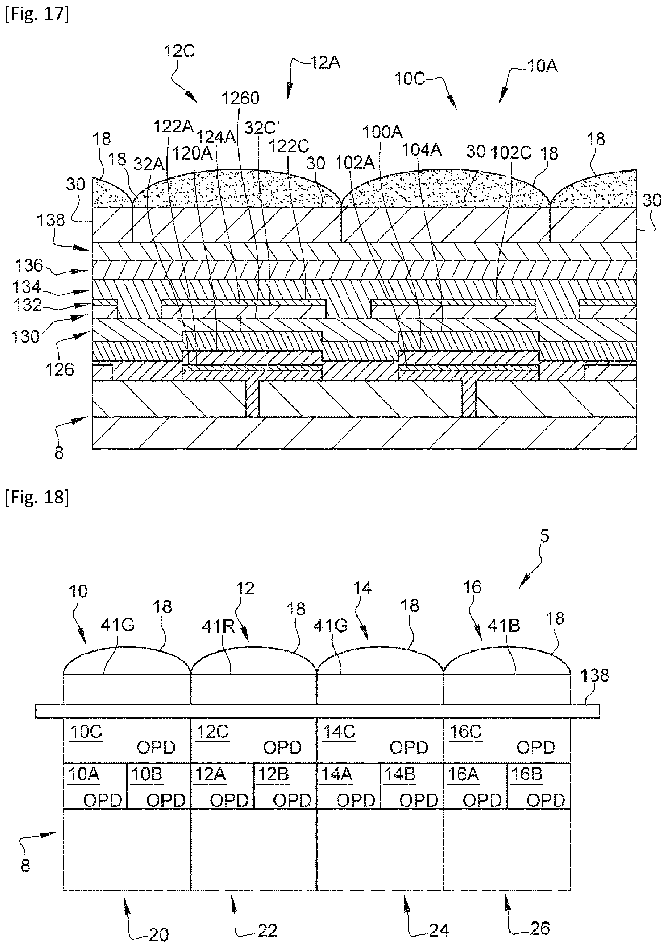

La figure 17 est une vue en coupe selon le plan BB (figure 2), schématique et partielle, du capteur d'images 1 des figures 1 et 2. Le plan de coupe BB correspond à un plan de coupe parallèle à une colonne de pixels du capteur d'images 1.

En figure 17, seuls les premiers photodétecteurs 10A, 12A et les troisièmes photodétecteurs 10C, 12C des pixels 10 et 12, respectivement, sont visibles. Dans l'exemple de la figure 17 :

l'électrode inférieure 102A du premier photodétecteur 10A du pixel 10 est séparée de l'électrode inférieure 122A du premier photodétecteur 12A du pixel 12 ;
l'électrode inférieure 102C du troisième photodétecteur 10C du pixel 10 est séparée de l'électrode inférieure 122C du troisième photodétecteur 12C du pixel 12 ;

la couche active 100A du premier photodétecteur 10A du pixel 10 et la couche active 120A du premier photodétecteur 12A du pixel 12 sont formées par un même dépôt continu ;

l'électrode supérieure 104A du premier photodétecteur 10A du pixel 10 et l'électrode supérieure 124A du premier photodétecteur 12A du pixel 12 sont formées par un autre même dépôt continu ;

la couche active du troisième photodétecteur 10C du pixel 10 et la couche active du troisième photodétecteur 12C du pixel 12 sont formées par la septième couche 134 ; et

l'électrode supérieure du troisième photodétecteur 10C du pixel 10 et l'électrode supérieure du troisième photodétecteur 12C du pixel 12 sont formées par la huitième couche 136.

En d'autres termes, tous les premiers photodétecteurs des pixels appartenant à une même colonne de pixels du capteur d'images 1 possèdent une couche active commune et une électrode supérieure commune. L'électrode supérieure permet ainsi d'adresser tous les premiers photodétecteurs des pixels d'une même colonne tandis que l'électrode inférieure permet d'adresser chaque premier photodétecteur de façon individuelle.

De façon analogue, tous les deuxièmes photodétecteurs des pixels appartenant à une même colonne de pixels du capteur d'images 1 possèdent une autre couche active commune, distincte de la couche active commune des premiers photodétecteurs de ces mêmes pixels, et une autre électrode supérieure commune, distincte de l'électrode supérieure commune des premiers photodétecteurs de ces mêmes pixels. Cette autre électrode supérieure commune permet ainsi d'adresser tous les deuxièmes photodétecteurs des pixels d'une même colonne tandis que l'électrode inférieure permet d'adresser chaque deuxième photodétecteur de façon individuelle.

Tous les troisièmes photodétecteurs des pixels du capteur d'images 1 possèdent encore une autre couche active commune, distincte des couches actives communes des premiers et deuxièmes photodétecteurs de ces mêmes pixels, et encore une autre électrode supérieure commune, distincte des électrodes supérieures communes des premiers et deuxièmes photodétecteurs de ces mêmes pixels. Cette électrode supérieure commune aux troisièmes photodétecteurs permet ainsi d'adresser les troisièmes photodétecteurs de tous les pixels du capteur d'images 1 tandis que l'électrode inférieure permet d'adresser chaque troisième photodétecteur de façon individuelle.

La figure 18 est une vue en coupe, schématique et partielle, d'un autre mode de réalisation d'un capteur d'images 5.

Le capteur d'images 5 représenté en figure 18 est analogue au capteur d'images 1 exposé en relation avec les figures 1 et 2. Ce capteur d'images 5 diffère du capteur d'images 1 principalement en ce que :

les pixels 10, 12, 14 et 16 du capteur d'images 5 sont disposés le long d'une même ligne ou d'une même colonne de ce capteur d'images 5 (tandis que les pixels 10, 12, 14 et 16 du capteur d'images 1 (figure 1) sont répartis sur deux lignes et deux colonnes différentes de ce capteur d'images 1) ; et

les filtres couleur 30 des pixels 10, 12, 14 et 16 du capteur d'images 1 (figure 1) sont remplacés, dans le capteur d'images 5, par des filtres couleur 41R, 41G et 41B situés entre les microlentilles 18 et la couche de passivation 138. En d'autres termes, les quatre pixels monochromatiques 10, 12, 14 et 16 disposés en carré en figure 1 sont ici mis côte à côte en figure 18.

Plus précisément, selon ce mode de réalisation, le capteur d'images 5 comporte :

un premier filtre vert 41G, intercalé entre la microlentille 18 du pixel 10 et la couche de passivation 138 ;

un filtre rouge 41R, intercalé entre la microlentille 18 du pixel 12 et la couche de passivation 138 ;

un deuxième filtre vert 41G, intercalé entre la microlentille 18 du pixel 14 et la couche de passivation 138 ; et

un filtre bleu 41B, intercalé entre la microlentille 18 du pixel 16 et la couche de passivation 138.

Toujours selon ce mode de réalisation, les filtres couleur 41R, 41G et 41B du capteur d'images 5 laissent passer les ondes électromagnétiques dans des plages de fréquences différentes du spectre visible et laissent passer les ondes électromagnétiques du spectre infrarouge. Les filtres couleur 41R, 41G et 41B peuvent correspondre à des blocs de résine colorée. Chaque filtre couleur 41R, 41G et 41B est adapté à laisser passer le rayonnement infrarouge, par exemple à une longueur d'onde comprise entre 700 nm et 1 mm, et, pour au moins certains des filtres couleur, à laisser passer une plage de longueurs d'onde de la lumière visible.

Pour chaque pixel d'une image couleur à acquérir, le capteur d'images 5 peut comprendre :

au moins un pixel (par exemple, le pixel 16) dont le filtre couleur 41B est adapté à laisser passer le rayonnement infrarouge et la lumière bleue, par exemple dans la plage de longueurs d'onde de 430 nm à 490 nm ;

au moins un pixel (par exemple, les pixels 10 et 14) dont le filtre couleur 41G est adapté à laisser passer le rayonnement infrarouge et la lumière verte, par exemple dans la plage de longueurs d'onde de 510 nm à 570 nm ; et

au moins un pixel (par exemple, le pixel 12) dont le filtre couleur 41R est adapté à laisser passer le rayonnement infrarouge et la lumière rouge, par exemple dans la plage de longueurs d'onde de 600 nm à 720 nm.

De façon analogue au capteur d'images 1 exposé en relation avec les figures 1 et 2, chaque pixel 10, 12, 14, 16 du capteur d'images 5 dispose d'un premier et d'un deuxième photodétecteur, ces premier et deuxième photodétecteurs étant adaptés à évaluer une distance par temps de vol, et d'un troisième photodétecteur adapté à capturer une image. Chaque pixel comporte ainsi trois photodétecteurs, représentés chacun de façon très schématique en figure 18 par des blocs (OPD).

De façon analogue au capteur d'images 1, dans le capteur d'images 5 :

le pixel 10 comporte le premier photodétecteur 10A, le deuxième photodétecteur 10B et le troisième photodétecteur 10C ;
le pixel 12 comporte le premier photodétecteur 12A, le deuxième photodétecteur 12B et le troisième photodétecteur 12C ;
le pixel 14 comporte le premier photodétecteur 14A, le deuxième photodétecteur 14B et le troisième photodétecteur 14C ; et
le pixel 16 comporte le premier photodétecteur 16A, le deuxième photodétecteur 16B et le troisième photodétecteur 16C.

Dans le capteur d'images 5, les premiers et deuxièmes photodétecteurs de chaque pixel 10, 12, 14 et 16 sont coplanaires. Les troisièmes photodétecteurs de chaque pixel 10, 12, 14 et 16 sont coplanaires et superposés aux premiers et deuxièmes photodétecteurs. Les premiers, deuxièmes et troisièmes photodétecteurs des pixels 10, 12, 14 et 16 sont respectivement associés à des circuits de lecture 20, 22, 24, 26. Ces circuits de lecture sont réalisés sur et à l'intérieur du support CMOS 8. Le capteur d'images 5 est ainsi capable, par exemple, de réaliser alternativement ou simultanément des estimations de distance par temps de vol et des captures d'images en couleur.

Selon un mode de réalisation, les couches actives des premiers et deuxièmes photodétecteurs des pixels du capteur d'images 5 sont constituées d'un matériau différent de celui dont sont constituées les couches actives des troisièmes photodétecteurs. Selon cet autre mode de réalisation :

le matériau dont sont constituées les couches actives des premiers et deuxièmes photodétecteurs est capable d'absorber les ondes électromagnétiques d'une partie du spectre infrarouge, de préférence l'infrarouge proche ; et
le matériau dont sont constituées les couches actives des troisièmes photodétecteurs est capable d'absorber les ondes électromagnétiques du spectre visible tout en laissant passer les ondes électromagnétiques du spectre infrarouge. La couche active 134, combinée à un filtre couleur 41R, 41G ou 41B, permet ainsi de filtrer la lumière visible qui n'est pas captée par les photodétecteurs utilisés pour l'évaluation de distance par temps de vol.

On peut alors utiliser le capteur d'images 5 pour réaliser, de façon alternative ou simultanée :

des évaluations de distance par temps de vol grâce aux premiers et deuxièmes photodétecteurs, en les pilotant, par exemple, comme exposé en relation avec la figure 4 ; et
des images en couleur grâce aux troisièmes photodétecteurs, en pilotant, par exemple, ces troisièmes photodétecteurs de façon synchronisée.

Un avantage de ce mode de réalisation préféré est que le capteur d'images 5 est alors capable de superposer, sur une image couleur, des informations issues de l'évaluation de distance par temps de vol. On peut ainsi imaginer un mode de mise en œuvre du fonctionnement du capteur d'images 5 permettant, par exemple, de produire une image couleur d'un sujet et d'inclure, pour chaque pixel de cette image couleur, une information représentative de la distance séparant le capteur d'images 5 de la zone du sujet représentée par le pixel considéré. En d'autres termes, le capteur d'images 5 peut réaliser une image tridimensionnelle d'une surface d'un objet, d'un visage, d'une scène, etc.

Enfin, la mise en œuvre pratique des modes de réalisation et variantes décrits est à la portée de l'homme du métier à partir des indications fonctionnelles données ci-dessus. En particulier, l'adaptation du pilotage des circuits de lecture des capteurs d'images 1 et 5 à d'autres modes de fonctionnement, par exemple pour la réalisation d'images infrarouges avec ou sans lumière ajoutée, la réalisation d'images avec suppression de fond et la réalisation d'images à grande gamme dynamique (HDR simultané) est à la portée de l'homme du métier à partir des indications ci-dessus.

**Revendications**

1. Pixel (10, 12, 14, 16) comportant :

un support CMOS (8) ;
exactement un premier photodétecteur organique (10A, 12A, 14A, 16A), un deuxième photodétecteur organique (10B, 12B, 14B, 16B) et un troisième photodétecteur organique (10C, 12C, 14C, 16C) ; et
une même lentille (18) à l'aplomb des premier, deuxième et troisième photodétecteurs organiques,
dans lequel les premier et deuxième photodétecteurs organiques comportent une première couche active (120, 100A, 120A, 120B, 160A), constituée d'un même premier matériau, et le troisième photodétecteur organique comporte une deuxième couche active (134), constituée d'un deuxième matériau, différent du premier matériau, adapté à absorber les ondes électromagnétiques du spectre visible, **caractérisé en ce que** le premier matériau est adapté à absorber les ondes électromagnétiques d'une partie du spectre infrarouge.

2. Capteur d'images (1 ; 5) comportant plusieurs pixels selon la revendication 1.

3. Procédé de fabrication d'un pixel selon la revendication 1 ou d'un capteur d'images selon la revendication 2, comprenant des étapes consistant à :

   prévoir le support CMOS (8) ;
   réaliser les premier (10A, 12A, 14A, 16A), deuxième (10B, 12B, 14B, 16B) et troisième (10C, 12C, 14C, 16C) photodétecteurs organiques de chaque pixel (10, 12, 14, 16) ; et
   réaliser la lentille (18) à l'aplomb des premier, deuxième et troisième photodétecteurs organiques de chaque pixel.

4. Pixel selon la revendication 1 ou capteur selon la revendication 2 ou procédé selon la revendication 3, dans lequel au moins deux photodétecteurs, parmi les premier (10A, 12A, 14A, 16A), deuxième (10B, 12B, 14B, 16B) et troisième (10C, 12C, 14C, 16C) photodétecteurs organiques, sont superposés.

5. Pixel selon la revendication 1 ou 4, ou capteur selon la revendication 2 ou 4, ou procédé selon la revendication 3 ou 4, dans lequel au moins deux photodétecteurs, parmi les premier (10A, 12A, 14A, 16A), deuxième (10B, 12B, 14B, 16B) et troisième (10C, 12C, 14C, 16C) photodétecteurs organiques, sont coplanaires.

6. Pixel selon la revendication 1, 4 ou 5, ou capteur selon la revendication 2, 4 ou 5, ou procédé selon l'une quelconque des revendications 3 à 5, dans lequel les premier (10A, 12A, 14A, 16A), deuxième (10B, 12B, 14B, 16B) et troisième (10C, 12C, 14C, 16C) photodétecteurs organiques sont séparés les uns des autres par un diélectrique (126 ; 128, 1280, 1282, 1284).

7. Pixel selon l'une quelconque des revendications 1, 4 à 6, ou capteur selon l'une quelconque des revendications 2, 4 à 6, ou procédé selon l'une quelconque des revendications 3 à 6, dans lequel chaque premier (10A, 12A, 14A, 16A), deuxième (10B, 12B, 14B, 16B) et troisième (10C, 12C, 14C, 16C) photodétecteur organique comporte une première électrode (102A, 102B, 102C, 122A, 122B, 122C, 162C), distincte de premières électrodes des autres photodétecteurs organiques.

8. Pixel, capteur ou procédé selon la revendication 7, dans lequel chaque première électrode (102A, 102B, 102C, 122A, 122B, 122C, 162C) est reliée, de préférence connectée, à un circuit de lecture (20A, 20B, 20C), chaque circuit de lecture comportant, de préférence, trois transistors (200, 202, 210) formés dans le support CMOS (8).

9. Pixel, capteur ou procédé selon la revendication 7 ou 8, dans lequel, pour chaque pixel (10, 12, 14, 16) :

   le premier photodétecteur organique (10A, 12A, 14A, 16A) est connecté à une deuxième électrode (104A, 124A, 164A) ;
   le deuxième photodétecteur organique (10B, 12B, 14B, 16B) est connecté à une troisième électrode (104B, 124B) ; et
   le troisième photodétecteur organique (10C, 12C, 14C, 16C) est connecté à une quatrième électrode (104C).

10. Pixel selon l'une quelconque des revendications 1, 4 à 9, ou capteur selon l'une quelconque des revendications 2, 4 à 9, ou procédé selon l'une quelconque des revendications 3 à 9, dans lequel les premier (10A, 12A, 14A, 16A), deuxième (10B, 12B, 14B, 16B) et troisième (10C, 12C, 14C, 16C) photodétecteurs organiques sont adaptés à évaluer une distance par temps de vol.

11. Pixel selon l'une quelconque des revendications 1, 4 à 10, ou capteur selon l'une quelconque des revendications 2, 4 à 10, ou procédé selon l'une quelconque des revendications 3 à 10, dans lequel le troisième photodétecteur organique (10C, 12C, 14C, 16C) est superposé aux premier (10A, 12A, 14A, 16A) et deuxième (10B, 12B, 14B, 16B) photodétecteurs organiques, les premier et deuxième photodétecteurs organiques étant coplanaires.

12. Pixel selon l'une quelconque des revendications 1, 4 à 11, ou capteur selon l'une quelconque des revendications 2, 4 à 11, ou procédé selon l'une quelconque des revendications 3 à 11, dans lequel, pour chaque pixel (10, 12, 14, 16), le premier photodétecteur organique (10A, 12A, 14A, 16A) et le deuxième photodétecteur organique (10B, 12B, 14B, 16B) sont de forme rectangulaire et s'inscrivent conjointement dans un carré.

13. Pixel selon l'une quelconque des revendications 1, 4 à 12, ou capteur selon l'une quelconque des revendications 2, 4 à 12, adapté à fonctionner :

dans une partie du spectre infrarouge ;
en lumière structurée ;
en imagerie à grande gamme dynamique, HDR ; et/ou avec suppression de fond.

14. Capteur selon l'une quelconque des revendications 2, 4 à 13, dans lequel chaque pixel (10, 12, 14, 16) comporte en outre, sous la lentille (18), un filtre couleur (30 ; 41R, 41G, 41B) laissant passer les ondes électromagnétiques dans une plage de fréquences du spectre visible et dans le spectre infrarouge.

15. Capteur selon la revendication 14, adapté à capter une image couleur.

16. Capteur selon la revendication 9, dans lequel :

la deuxième électrode (104A, 124A, 164A) est commune à tous les premiers photodétecteurs organiques (10A, 12A, 14A, 16A) des pixels (10, 12, 14, 16) du capteur (1 ; 5) ;
la troisième électrode (104B, 124B) est commune à tous les deuxièmes photodétecteurs organiques (10B, 12B, 14B, 16B) des pixels du capteur ; et
la quatrième électrode (104C) est commune à tous les troisièmes photodétecteurs organiques (10C, 12C, 14C, 16C) des pixels du capteur.

## Patentansprüche

1. Ein Pixel (10, 12, 14, 16), das Folgendes aufweist:

einen CMOS-Träger (8);
genau einen ersten organischen Photodetektor (10A, 12A, 14A, 16A), einen zweiten organischen Photodetektor (10B, 12B, 14B, 16B) und einen dritten organischen Photodetektor (10C, 12C, 14C, 16C); und
eine gleiche Linse (18), die sich vertikal in einer Linie mit dem ersten, zweiten und dritten organischen Photodetektor befindet,

wobei der erste und der zweite organische Photodetektor eine erste aktive Schicht (120, 100A, 120A, 120B, 160A) aufweisen, die aus demselben ersten Material hergestellt ist, und der dritte organische Photodetektor eine zweite aktive Schicht (134) aufweist, die aus einem zweiten Material hergestellt ist, das sich von dem ersten Material unterscheidet und in der Lage ist, die elektromagnetischen Wellen des sichtbaren Spektrums zu absorbieren, **dadurch gekennzeichnet, dass** das erste Material in der Lage ist, die elektromagnetischen Wellen eines Teils des Infrarotspektrums zu absorbieren.

2. Ein Bildsensor (1; 5) mit einer Vielzahl von Pixeln nach Anspruch 1.

3. Ein Verfahren zur Herstellung des Pixels nach Anspruch 1 oder des Bildsensors nach Anspruch 2, das die folgenden Schritte aufweist:

Bereitstellen des CMOS-Trägers (8);
Bilden des ersten (10A, 12A, 14A, 16A), zweiten (10B, 12B, 14B, 16B) und dritten (10C, 12C, 14C, 16C) organischen Photodetektors jedes Pixels (10, 12, 14, 16); und
Bilden der Linse (18) vertikal in einer Linie mit dem ersten, zweiten und dritten organischen Photodetektor jedes Pixels.

4. Pixel nach Anspruch 1 oder Sensor nach Anspruch 2 oder Verfahren nach Anspruch 3, wobei mindestens zwei Photodetektoren unter den ersten (10A, 12A, 14A, 16A), zweiten (10B, 12B, 14B, 16B) und dritten (10C, 12C, 14C, 16C) organischen Photodetektoren gestapelt sind.

5. Pixel nach Anspruch 1 oder 4 oder Sensor nach Anspruch 2 oder 4 oder Verfahren nach Anspruch 3 oder 4, wobei mindestens zwei Photodetektoren unter den ersten (10A, 12A, 14A, 16A), zweiten (10B, 12B, 14B, 16B) und dritten (10C, 12C, 14C, 16C) organischen Photodetektoren koplanar sind.

6. Pixel nach Anspruch 1, 4 oder 5 oder Sensor nach Anspruch 2, 4 oder 5 oder Verfahren nach einem der Ansprüche 3 bis 5, wobei der erste (10A, 12A, 14A, 16A), zweite (10B, 12B, 14B, 16B) und dritte (10C, 12C, 14C, 16C) organische Photodetektor durch ein Dielektrikum (126; 128, 1280, 1282, 1284) voneinander getrennt sind.

7. Pixel nach Anspruch 1, 4 bis 6, oder Sensor nach Anspruch 2, 4 bis 6, oder Verfahren nach einem der Ansprüche 3 bis 6, wobei jeder erste (10A, 12A, 14A, 16A), zweite (10B, 12B, 14B, 16B) und dritte (10C, 12C, 14C, 16C) organische Photodetektor eine erste Elektrode (102A, 102B, 102C, 122A, 122B, 122C, 162C) aufweist, die von den ersten Elektroden der anderen organischen Photodetektoren getrennt ist.

8. Pixel, Sensor oder Verfahren nach Anspruch 7, wobei jede erste Elektrode (102A, 102B, 102C, 122A, 122B, 122C, 162C) mit einer Ausleseschaltung (20A, 20B, 20C) gekoppelt, vorzugsweise verbunden, ist, wobei jede Ausleseschaltung vorzugsweise drei Transistoren (200, 202, 210) aufweist, die in dem CMOS-Träger (8) ausgebildet sind.

9. Pixel, Sensor oder Verfahren nach Anspruch 7 oder 8, wobei für jedes Pixel (10, 12, 14, 16):

der erste organische Photodetektor (10A, 12A, 14A, 16A) mit einer zweiten Elektrode (104A, 124A, 164A) verbunden ist;
der zweite organische Photodetektor (10B, 12B, 14B, 16B) mit einer dritten Elektrode (104B, 124B) verbunden ist; und
der dritte organische Fotodetektor (10C, 12C, 14C, 16C) mit einer vierten Elektrode (104C) verbunden ist.

10. Pixel nach einem der Ansprüche 1, 4 bis 9 oder Sensor nach einem der Ansprüche 2, 4 bis 9 oder Verfahren nach einem der Ansprüche 3 bis 9, wobei der erste (10A, 12A, 14A, 16A), der zweite (10B, 12B, 14B, 16B) und der dritte (10C, 12C, 14C, 16C) organische Photodetektor in der Lage sind, eine Entfernung anhand der Laufzeit zu schätzen.

11. Pixel nach einem der Ansprüche 1, 4 bis 10 oder Sensor nach einem der Ansprüche 2, 4 bis 10 oder Verfahren nach einem der Ansprüche 3 bis 10, wobei der dritte organische Photodetektor (10C, 12C, 14C, 16C) auf den ersten (10A, 12A, 14A, 16A) und zweiten (10B, 12B, 14B, 16B) organischen Photodetektor gestapelt ist, wobei der erste und zweite organische Photodetektor koplanar sind.

12. Pixel nach einem der Ansprüche 1, 4 bis 11 oder Sensor nach einem der Ansprüche 2, 4 bis 11 oder Verfahren nach einem der Ansprüche 3 bis 11, wobei für jedes Pixel (10, 12, 14, 16) der erste organische Photodetektor (10A, 12A, 14A, 16A) und der zweite organische Photodetektor (10B, 12B, 14B, 16B) eine rechteckige Form aufweisen und gemeinsam in ein Quadrat eingeschrieben sind.

13. Pixel nach einem der Ansprüche 1, 4 bis 12 oder Sensor nach einem der Ansprüche 2, 4 bis 12, der in der Lage ist, zu arbeiten:

in einem Teil des Infrarotspektrums;
in strukturiertem Licht;
in der Bildgebung mit hohem Dynamikbereich, HDR; und/oder mit einer Hintergrundunterdrückung.

14. Bildsensor nach einem der Ansprüche 2, 4 bis 13, wobei jedes Pixel (10, 12, 14, 16) unter der Linse (18) einen Farbfilter (30; 41R, 41G, 41B) aufweist, der für elektromagnetische Wellen in einem Frequenzbereich des sichtbaren Spektrums und im Infrarotspektrum durchlässig ist.

15. Bildsensor nach Anspruch 14, der in der Lage ist, ein Farbbild zu erfassen.

16. Sensor nach Anspruch 9, wobei:

die zweite Elektrode (104A, 124A, 164A) allen ersten organischen Photodetektoren (10A, 12A, 14A, 16A) der Pixel (10, 12, 14, 16) des Sensors (1; 5) gemeinsam ist;
die dritte Elektrode (104B, 124B) allen zweiten organischen Photodetektoren (10B, 12B, 14B, 16B) der Pixel des Sensors gemeinsam ist; und
die vierte Elektrode (104C) allen dritten organischen Photodetektoren (10C, 12C, 14C, 16C) der Pixel des Sensors gemeinsam ist.

## Claims

1. A pixel (10, 12, 14, 16) comprising:

a CMOS support (8);
exactly a first organic photodetector (10A, 12A, 14A, 16A), a second organic photodetector (10B, 12B, 14B, 16B) and a third organic photodetector (10C, 12C, 14C, 16C) ; and
a same lens (18) vertically in line with said first, second and third organic photodetectors,
wherein the first and second organic photodetectors comprise a first active layer (120, 100A, 120A, 120B, 160A), made of a same first material, and the third organic photodetector comprises a second active layer (134), made of a second material, different from the first material, capable of absorbing the electromagnetic waves of the visible spectrum, **characterized in that** the first material is capable of absorbing the electromagnetic waves of part of the infrared spectrum.

2. An image sensor (1; 5) comprising a plurality of pixels according to claim 1.

3. A method of manufacturing the pixel according to claim 1 or the image sensor according to claim 2, comprising steps of:

providing the CMOS support (8);
forming the first (10A, 12A, 14A, 16A), second (10B, 12B, 14B, 16B) and third (10C, 12C, 14C, 16C) organic photodetectors of each pixel (10, 12, 14, 16); and
forming the lens (18) vertically in line with the first, second and third organic photodetectors of each pixel.

4. The pixel according to claim 1 or the sensor according to claim 2 or the method according to claim 3, wherein at least two photodetectors, among said first (10A, 12A, 14A, 16A), second (10B, 12B, 14B, 16B) and third (10C, 12C, 14C, 16C) organic photodetectors, are stacked.

5. The pixel according to claim 1 or 4, or the sensor according to claim 2 or 4, or the method according to claim 3 or 4, wherein at least two photodetectors, among said first (10A, 12A, 14A, 16A), second (10B, 12B, 14B, 16B) and third (10C, 12C, 14C, 16C) organic photodetectors, are coplanar.

6. The pixel according to claim 1, 4 or 5, or the sensor according to claim 2, 4 or 5, or the method according to any of claims 3 to 5, wherein said first (10A, 12A, 14A, 16A), second (10B, 12B, 14B, 16B) and third (10C, 12C, 14C, 16C) organic photodetectors are separated from one another by a dielectric (126; 128, 1280, 1282, 1284).

7. The pixel according to claim 1, 4 to 6, or the sensor according to claim 2, 4 to 6, or the method according to any of claims 3 to 6, wherein each first (10A, 12A, 14A, 16A), second (10B, 12B, 14B, 16B) and third (10C, 12C, 14C, 16C) organic photodetector comprises a first electrode (102A, 102B, 102C, 122A, 122B, 122C, 162C), separate from first electrodes of the other organic photodetectors.

8. The pixel, sensor, or method according to claim 7, wherein each first electrode (102A, 102B, 102C, 122A, 122B, 122C, 162C) is coupled, preferably connected, to a readout circuit (20A, 20B, 20C), each readout circuit preferably comprising three transistors (200, 202, 210) formed in the CMOS support (8).

9. The pixel, sensor or method according to claim 7 or 8, wherein, for each pixel (10, 12, 14, 16):

the first organic photodetector (10A, 12A, 14A, 16A) is connected to a second electrode (104A, 124A, 164A);
the second organic photodetector (10B, 12B, 14B, 16B) is connected to a third electrode (104B, 124B); and
the third organic photodetector (10C, 12C, 14C, 16C) is connected to a fourth electrode (104C).

10. The pixel according to any of claims 1, 4 to 9, or the sensor according to any of claims 2, 4 to 9, or the method according to any of claims 3 to 9, wherein the first (10A, 12A, 14A, 16A), second (10B, 12B, 14B, 16B) and third (10C, 12C, 14C, 16C) organic photodetectors are capable of estimating a distance by time of flight.

11. The pixel according to any of claims 1, 4 to 10, or the sensor according to any of claims 2, 4 to 10, or the method according to any of claims 3 to 10, wherein the third organic photodetector (10C, 12C, 14C, 16C) is stacked to the first (10A, 12A, 14A, 16A) and second (10B, 12B, 14B, 16B) organic photodetectors, the first and second organic photodetectors being coplanar.

12. The pixel according to any of claims 1, 4 to 11, or the sensor according to any of claims 2, 4 to 11, or the method according to any of claims 3 to 11, wherein, for each pixel (10, 12, 14, 16), the first organic photodetector (10A, 12A, 14A, 16A) and the second organic photodetector (10B, 12B, 14B, 16B) have a rectangular shape and are jointly inscribed within a square.

13. The pixel according to any of claims 1, 4 to 12, or the sensor according to any of claims 2, 4 to 12, capable of operating:

in a portion of the infrared spectrum;
in structured light;
in high dynamic range imaging, HDR; and/or
with a background suppression.

14. The image sensor according to any of claims 2, 4 to 13, wherein each pixel (10, 12, 14, 16) further comprises, under the lens (18), a color filter (30; 41R, 41G, 41B) giving way to electromagnetic waves in a frequency range of the visible spectrum and in the infrared spectrum.

15. The image sensor according to claim 14, capable of capturing a color image.

16. The sensor according to claim 9, wherein:

the second electrode (104A, 124A, 164A) is common to all the first organic photodetectors (10A, 12A, 14A, 16A) of the pixels (10, 12, 14, 16) of the sensor (1; 5);
the third electrode (104B, 124B) is common to all the second organic photodetectors (10B, 12B, 14B, 16B) of the pixels of the sensor; and
the fourth electrode (104C) is common to all the third organic photodetectors (10C, 12C, 14C, 16C) of the pixels of the sensor.

[Fig. 1]

[Fig. 2]

[Fig. 3]

[Fig. 4]

EP 3 767 679 B1

[Fig. 5]

[Fig. 6]

[Fig. 7]

[Fig. 8]

[Fig. 9]

[Fig. 10]

[Fig. 11]

EP 3 767 679 B1

[Fig. 12]

[Fig. 13]

[Fig. 14]

[Fig. 15]

[Fig. 16]

EP 3 767 679 B1

29

[Fig. 17]

[Fig. 18]

## RÉFÉRENCES CITÉES DANS LA DESCRIPTION

**Documents brevets cités dans la description**

- DE 102016102111
- EP 2980850 A
- US 2019131349 A
- US 2015221702 A
- EP 3209012 A